# EUROPEAN PATENT APPLICATION

(11) **EP 1 608 005 A1**
(43) Date of publication of application: **21.12.2005**
(21) Application number: 04718432.0
(22) Date of filing: 08.03.2004
(51) Int. Cl.: H01L 21/205, H01L 21/31, C23C 16/448

(54) **VAPORIZER, FILM FORMING APPARATUS INCLUDING THE SAME, METHOD OF VAPORIZATION AND METHOD OF FORMING FILM**

(30) Priority: 07.03.2003 JP 2003062577
(71) Applicant: KABUSHIKI KAISHA WATANABE SHOKO, Chuo-ku, Tokyo 103-0022 (JP)
(72) Inventor: YAMOTO, Hisayoshi, c/o Wacom Electric Co., Ltd, Tokyo 103-0022 (JP); AKUTO, Kazuya, c/o Wacom Electric Co., Ltd., Tokyo 103-0022 (JP); NAGAOKA, Ken, c/o Wacom Electric Co., Ltd., Tokyo 103-0022 (JP); KOBAYASHI, Hitoshi, c/o Wacom Electric Co., Ltd., Tokyo 103-0022 (JP); SHOJI, Masafumi, c/o Wacom Electric Co., Ltd., Tokyo 103-0022 (JP); FUKAGAWA, Mitsuru, c/o Wacom Electric Co., Ltd., Tokyo 103-0022 (JP)
(74) Representative: Dr. Weitzel & Partner
(86) International application number: PCT/JP2004/002969
(87) International publication number: WO 2004/079806

(57) **Abstract**

It is aimed at providing a vaporization apparatus and a vaporization method capable of keeping track of a progressive condition of clogging of the apparatus. It is also aimed at providing a vaporization apparatus and a vaporization method capable of eliminating clogging prior to occurrence of complete clogging, without disassembling the apparatus. It provides a vaporization apparatus for introducing a carrier gas from one end of a gas passage and for feeding, the carrier gas including a material solution, from the other end of the gas passage to a vaporization part to thereby vaporize the material solution, **characterized in that** a mass flow controller (MFC) is provided at the one end of the gas passage, and means for detecting a pressure within the gas passage is provided. The vaporization apparatus is **characterized in that** the same is provided with means for introducing a chemical solution capable of dissolving therein matters deposited or sticked to the inside of the gas passage, into the gas passage.

## Description

### TECHNICAL FIELD

The present invention relates to a vaporizer, a vaporization method, a film-formation apparatus, and other various devices preferably usable for MOCVD, for example.

### BACKGROUND ART

Problematic in development of DRAM is a storage capacitance accompanying to scale-down for such a memory. Because capacitances are required to be at the same level as the former generation from a standpoint of soft error and the like, some countermeasures are necessary. As one countermeasure, it has been contemplated to increase each capacitor area by adopting a three-dimensional structure which is exemplarily called stack structure/trench structure for cell structures of 4M or more, though planar structures have been used in cell structures of 1M or less. Also, adopted as dielectric films are stacked films (which are typically called ON films) obtained by stacking thermal oxidation films and CVD nitride films on poly-Si, instead of thermal oxidation films on substrate Si. In 16M DRAM's, there have been adopted a thick film type utilizing side surfaces, a fin type utilizing reverse surfaces of a plate, or the like, in the stack type, so as to further increase a surface area contributing to each capacitance.

However, regarded as problems in such three-dimensional structures are an increased number of procedures due to a complicated process and a deteriorated yield due to increased step height differences, thereby leading to an assumption that more than 256M bits will be hardly realized. As such, there has been thought out an approach to replace a dielectric of a capacitance by a ferroelectric having a higher dielectric constant, as one solution for further increasing a degree of integration without changing a DRAM structure at the present time. Then, attention has been firstly directed to thin-films of oxides of paraelectric monometal having a higher dielectric constant such as Ta₂O₅, Y₂O₃, HfO₂, and the like, as dielectric thin-films having higher dielectric constants. Respective specific dielectric constants are 28 for Ta₂O₅, 16 for Y₂O₃, and about 24 for HfO₂, which are 4 to 7 times that of SiO₂.

There is still required, however, a three-dimensional capacitor structure for application of DRAM of more than 256M. There are accordingly so expected three kinds of materials for application to DRAM's, i.e., (BaₓSr₁-ₓ)TiO₃, Pb (Zr_{y}Ti_{1-y})O₃, and (PbₐL₁₋ₐ) (Zr_{b}Ti_{1-b})O₃, which have specific dielectric constants higher than the above oxides, respectively.

Further, attention has been recently and strongly directed to Bi-based laminar structures having crystal structures extremely analogous to those of superconductive materials, in that such laminar structures have higher dielectric constants, have self-polarization specific to a ferroelectric, and are excellent as nonvolatile memories.

Generally, SrBi₂TaO₉ ferroelectric thin-film formation is achieved by a practical and promising MOCVD (metalorganic chemical vapor deposition) method.

Examples of materials of ferroelectric thin-films include three kinds of organometallic complexes Sr(DPM)₂, Bi(C₆H₅)₃, and Ta(OC₂H₅)₅, which are each used as a material solution by dissolving them in solvents such as THF (tetrahydrofuran), hexane, and other solvents, respectively. Also used as material solutions are Sr(Ta(OEt)₆)₂, Bi(OtAm)₃, and the like, by dissolving them in hexane and other solvents, respectively. Note that DPM is an abbreviation of dipivaloyl methane.

characteristics of the respective materials are shown in Table 1.

**(Table 1)**

| Characteristics of materials for ferroelectric thin-films | | |
|---|---|---|
| | boiling point (°C) / pressure (mmHg) | melting point (°C) |
| Sr(DPM)₂ | 231/0.1 | 210 |
| Bi (C₆H₅)₃ | 130/0.1 | 80 |

| | | |
|---|---|---|
| Ta (OC₂H₅)₅ | 118/0.1 | 22 |
| THF | 67 | -109 |
| Sr(Ta(OEt)₆)₂ | 176/0.1 | 130 |
| Bi(OtAm)₃ | 87/0.1 | 90 |

Apparatuses used for an MOCVD method are each configured with: a reaction part configured to cause gas phase reaction and surface reaction of SrBi₂TaO₉ thin-film oriented materials to thereby achieve film formation thereof; and a supply part configured to supply the SrBi₂TaO₉ thin-film oriented materials and an oxidizing agent to the reaction part.

Further, the supply part is provided with a vaporizer configured to vaporize the thin-film materials.

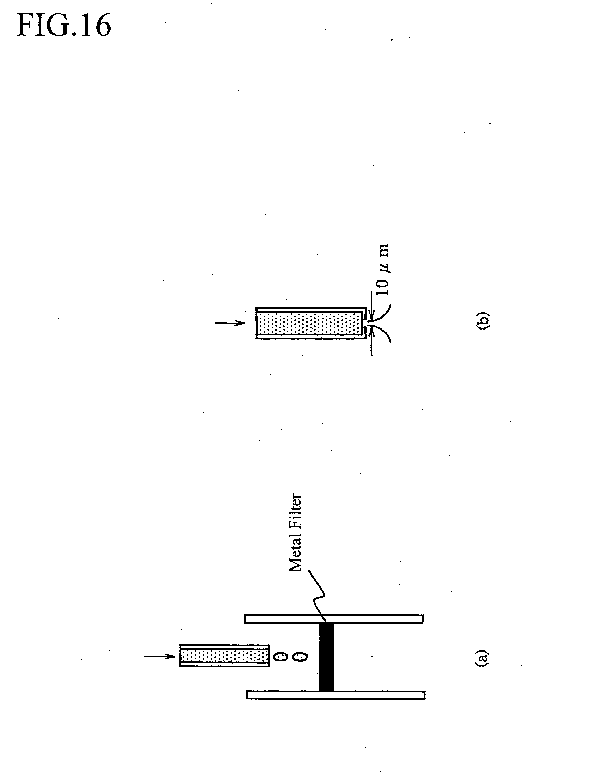

Conventionally known as techniques concerning vaporizers, are methods shown in FIG. 16. What is shown in FIG. 16(a) is called a metal filter type method configured to conduct vaporization by introducing a material solution heated to a predetermined temperature, into a metal filter to be used for the purpose of increasing a contact area between an SrBi₂TaO₉ ferroelectric thin-film oriented material solution and a gas present therearound.

However, this technique is problematic in that the metal filter is brought to be clogged by vaporization over several hours, and thus fails to withstand long-term usage. The present inventors have supposed that this is due to a fact that the solution is heated to vaporize components therein in an ascending order of vaporization temperature, from lower to higher.

FIG. 16(b) shows a technique for applying a pressure of 30kgf/cm² to a material solution so as to eject the material solution through a small hole of 10µm, thereby vaporizing the material solution by expansion.

However, also this technique is problematic in that the small hole is brought to be clogged by usage over several hours, and thus fails to withstand long-term usage.

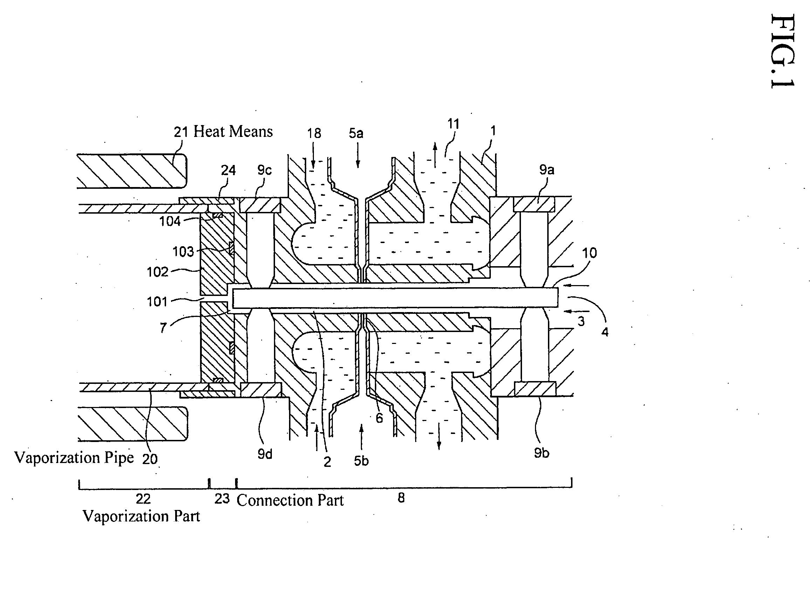

Further, in case that the material solution is a mixed solution of a plurality of organometallic complexes such as Sr (DPM)₂/THF, Bi (C₆H₅)₃/THF, and Ta(OC₂H₅)₅/THF, and that the mixed solution is to be vaporized by heating, the solvent (THF in this case) having the highest vapor pressure is vaporized first such that the organometallic complexes are deposited and sticked onto a heated surface, thereby leading to a problem that the materials are not stably supplied to the reaction part. In all the methods shown in FIG. 1, such calories are applied to the solvents in a liquid or mist state, which are sufficient to vaporize or alter the solvents, respectively.

Further, to obtain a film excellent in uniformity in the MOCVD, it is required to provide a vaporizedly obtained gas including uniformly dispersed material solutions. However, the above-mentioned related art is not necessarily capable of meeting such a requirement.

To meet such a requirement, the present inventors have separately provided the following technique.

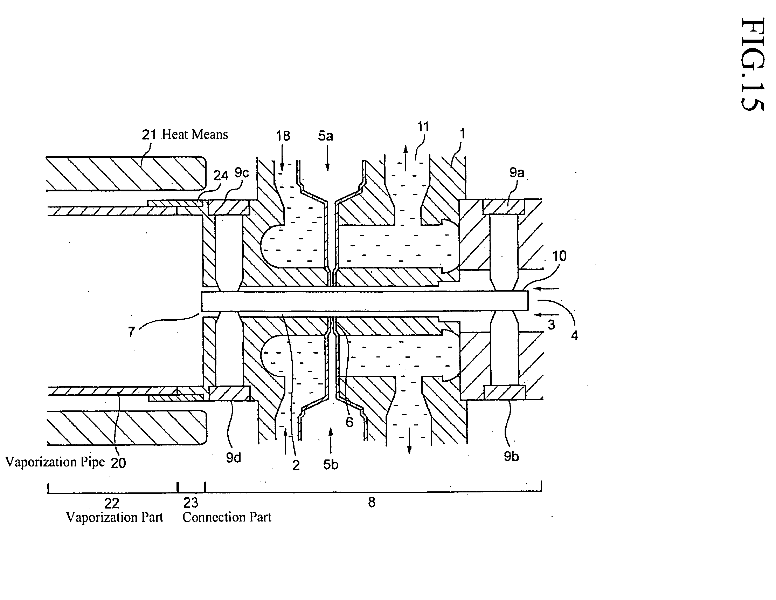

Namely, as shown in FIG. 15, it is an MOCVD oriented vaporizer including:
(1) a dispersion part having: a gas passage formed therein; a gas inlet for introducing a pressurized carrier gas into the gas passage; means for supplying material solutions into the gas passage; a gas outlet for feeding the carrier gas including the material solutions to a vaporization part; means for cooling the gas passage; and a radiant heat preventing ejection part cooled to prevent a thermal energy from being transmitted to the material gas in the dispersion part due to a radiant heat from the vaporization part; and
(2) a vaporization part having: a vaporization pipe having one end connected to a reaction tube of an MOCVD apparatus, and other end connected to the gas outlet; and heat means for heating the vaporization pipe, in which the vaporization part is adapted to heat the carrier gas including the material solutions fed from the dispersion part to thereby vaporize the material solutions;
so that the thermal energy due to the radiant heat from the vaporization part is not applied to the material gas in the dispersion part.

This technique is an MOCVD oriented vaporizer which is extremely less in clogging, usable over a longer period of time, and capable of supplying a material to the reaction part in a more stabilized manner, than the conventional.

Further, this technique includes an inlet of previously heated oxygen, in the downstream of the vaporization part.

However, even by this technique, there is found deposition of crystal on the passage of gas to thereby possibly cause clogging.

In turn, there is contained a large amount of carbon (30 to 40at%) in the formed film. This leads to a necessity of annealing the film at a high temperature (at 800°C for 60 minutes in an oxygen atmosphere, for example) after film formation, so as to eliminate such carbon.

Moreover, there is caused a considerable variance in composition ratio, in case of conducting film formation.

The present applicant has filed a technique for solving the above problem, as a patent application. Namely, the invention in such a patent application has the following objects. The objects are to provide a vaporizer capable of long-term usage without clogging and the like, and capable of stable supply of a material to a reaction part.

It is therefore an object of the present invention to provide a vaporizer, a film-formation apparatus, other various devices, and a vaporizing method capable of extremely decreasing a content of carbon in a film even in an as-deposited state thereof, and capable of precisely controlling a composition ratio of the film.

It is another object of the present invention to provide a vaporizer and a vaporization method capable of providing a vaporizedly obtained gas including uniformly dispersed material solutions.

Meanwhile, the technique noted above is not still perfect in prevention of occurrence of clogging, and has not completely succeeded in keeping track of a progressive condition of clogging during film formation.

Further, it is difficult to eliminate complete clogging upon occurrence thereof, thereby leading to disassembling of the apparatus for elimination of such a clogging state.

It is therefore still another object of the present invention to provide a vaporization apparatus and a vaporization method capable of keeping track of a progressive condition of clogging in the apparatus.

It is yet another object of the present invention to provide a vaporization apparatus and a vaporization method capable of eliminating clogging before complete clogging, without disassembling the apparatus.

### DISCLOSURE OF THE INVENTION

The present invention resides in a vaporization apparatus for introducing a carrier gas from one end of a gas passage and for feeding, the carrier gas including a material solution, from the other end of the gas passage to a vaporization part to thereby vaporize the material solution, characterized in
that a mass flow controller (MFC) is provided at the one end of the gas passage, and means (hereinafter called "pressure detection means") for detecting a pressure within the gas passage is provided.

It is characterized in that the vaporization apparatus is provided with means (hereinafter called "dissolution chemical solution supply means") for introducing a chemical solution capable of dissolving therein matters (hereinafter called "deposited matters and the like") deposited or sticked to the inside of the gas passage, into the gas passage.

It is characterized in that the chemical solution is a solvent of the material solution.

It is characterized in that the other end of the gas passage is smaller in diameter than the remaining portion thereof.

It is characterized in that the other end has a diameter of 2mm or less.

It is characterized in that the vaporization apparatus is provided with means for displaying a signal from the pressure detection means.

The present invention resides in a vaporization method for introducing a carrier gas from one end of a gas passage and for feeding, the carrier gas including a material solution, from the other end of the gas passage to a vaporization part to thereby vaporize the material solution, characterized in that the method comprises the steps of:
providing a mass flow controller (MFC) at the one end of the gas passage, and
conducting vaporization while detecting a pressure within the gas passage.

It is characterized in that the method further comprises the step of: introducing a chemical solution capable of dissolving therein deposited matters and the like, when the pressure has reached a predetermined value or more.

It is characterized in that the chemical solution is a solvent of the material solution.

It is characterized in that the other end of the gas passage is smaller in diameter than the remaining portion thereof.

It is characterized in that the other end has a diameter of 2mm or less.

It is characterized in that the method further comprises the step of: displaying the pressure.

The present invention resides in a film-formation apparatus characterized in that the film-formation apparatus is provided with any one of the above recited vaporization apparatuses.

It is characterized in that the film-formation apparatus is an MOCVD apparatus.

The present invention resides in a film-formation method characterized in that the method comprises the step of: conducting film-formation by vaporization by any one of the vaporization method.

It is characterized in that the film-formation method is an MOCVD method.

The present invention resides in another film-formation apparatus for conducting film-formation on a surface of a strip-shaped substrate while continuously feeding the strip-shaped substrate, characterized in that the film-formation apparatus is provided with a plurality of any ones of the vaporization apparatuses in a manner to oppose to the surface of the strip-shaped substrate.

The present invention resides in a film-formation method using the film-formation apparatus, characterized in that the film-formation method comprises the step of:
turning ON dissolution chemical solution supply means in any one of the plurality of vaporizers, while continuously conducting vaporization in the remaining vaporizers to continuously conduct film-formation.

It is also applicable in a conventional vaporizer such as that having a structure shown in FIG. 1 of JP-A-3-126872 and that having a structure shown in FIG. 2 of JP-A-2002-110546, to provide the pressure detection means of the present invention, and to wash the gas passage including the outlet based on the pressure information obtained by the pressure detection means. Further, it is also applicable to vaporizers having structures shown in FIG. 26, respectively.

It is preferably applied to the following vaporizers or vaporizing methods.

A vaporizer characterized in that the vaporizer comprises:
(1) a dispersion part having:
   a gas passage formed therein;
   a gas inlet for introducing a carrier gas into the gas passage;
   means for supplying a material solution into the gas passage;
   a gas outlet for feeding the carrier gas including the material solution to a vaporization part; and
   means for cooling the gas passage; and
(2) a vaporization part having:
   a vaporization pipe having one end connected to a reaction part of a film-formation apparatus or any one of other various devices, and other end connected to the gas outlet; and
   heat means for heating the vaporization pipe,
in which the vaporization part is adapted to heat the carrier gas including the atomized material solution fed from the dispersion part to thereby vaporize the atomized material solution;
wherein the vaporizer is provided with a radiation prevention part having a small hole outside the gas outlet.

A vaporizer characterized in that the vaporizer comprises:
(1) a dispersion part having:
   a gas passage formed therein;
   a gas inlet for introducing a pressurized carrier gas into the gas passage;
   means for supplying a material solution into the gas passage; and
   a gas outlet for feeding the carrier gas including the material solution to a vaporization part; and
(2) a vaporization part having:
   a vaporization pipe having one end connected to a reaction part of a film-formation apparatus or any one of other various devices, and other end connected to the gas outlet; and
   heat means for heating the vaporization pipe,
   in which the vaporization part is adapted to heat the carrier gas including the material solution fed from the dispersion part to thereby vaporize the material solution;
(3) wherein the dispersion part has a dispersion part body having a cylindrical or conical hollow, and a rod having an outer diameter smaller than an inner diameter of the cylindrical or conical hollow; and
   the rod has one or two or more helical flutes on an outer periphery of the rod at the vaporizer side, and is inserted in the cylindrical or conical hollow; and
(4) wherein there is provided, outside the gas outlet, a cooled radiation prevention part having a small hole at the gas outlet side and having an inner diameter widened in a tapered shape toward the vaporizer side.

A vaporizer characterized in that the vaporizer comprises:
(1) a dispersion part having:
   a gas passage formed therein;
   a gas inlet for introducing a carrier gas into the gas passage;
   means for supplying a material solution into the gas passage;
   a gas outlet for feeding the carrier gas including the material solution to a vaporization part; and
   means for cooling the gas passage; and
(2) a vaporization part having:
   a vaporization pipe having one end connected to a reaction part of a film-formation apparatus or any one of other various devices, and other end connected to the gas outlet; and
   heat means for heating the vaporization pipe,
in which the vaporization part is adapted to heat the carrier gas including the material solution fed from the dispersion part to thereby vaporize the material solution;
wherein the carrier gas is obtained by adding a slight amount oxidative gas into Ar, N₂, helium or the like, and is introduced from the gas inlet in the method, or an oxidative gas or a mixed gas thereof is allowed to be introduced from a primary oxygen supply port closest to an ejection part.

A vaporizer of the present invention characterized in that the vaporizer comprises:
(1) a dispersion part having:
   a gas passage formed therein;
   a gas inlet for introducing a carrier gas into the gas passage;
   means for supplying a material solution into the gas passage;
   a gas outlet for feeding the carrier gas including the material solution to a vaporization part; and
   means for cooling the gas passage; and
(2) a vaporization part having:
   a vaporization pipe having one end connected to a reaction part of a film-formation apparatus or any one of other various devices, and other end connected to the gas outlet; and
   heat means for heating the vaporization pipe,
in which the vaporization part is adapted to heat the carrier gas including the material solution fed from the dispersion part to thereby vaporize the material solution;
wherein the vaporizer is provided with a radiation prevention part having a small hole outside the gas outlet, and
wherein the carrier gas and an oxidative gas are allowed to be introduced from the gas inlet.

A vaporization method comprising the steps of:
introducing a material solution into a gas passage; jetting a high-speed carrier gas toward the introduced material solution to thereby shear and atomize the material solution to establish a material gas; and then supplying the material gas to a vaporization part to thereby vaporize the same; characterized in that the carrier gas contains oxygen therein.

A vaporizer characterized in that the vaporizer is formed with:
a plurality of solution passages for supplying a plurality of material solutions, respectively;
a mixing part configured to mix the plurality of material solutions supplied from the plurality of solution passages, respectively, with one another;
a supply passage having one end communicated with the mixing part, and an outlet located at a vaporizer side;
a gas passage arranged to blow a carrier gas or a mixed gas of carrier gas and oxygen to the material solutions exited from the mixing part; and
cooling means for cooling the supply passage.

A disperser characterized in that the disperser comprises:
a disperser formed with:
   a plurality of solution passages for supplying a plurality of material solutions, respectively;
   a mixing part configured to mix the plurality of material solutions supplied from the plurality of solution passages, respectively, with one another;
   a supply passage having one end communicated with the mixing part, and an outlet located at a vaporizer side;
   a gas passage arranged to blow a carrier gas or a mixed gas of carrier gas and oxygen to the material solutions exited from the mixing part; and
   cooling means for cooling the supply passage; and
a vaporization part having:
   a vaporization pipe having one end connected to a reaction part of a film-formation apparatus or any one of other various devices, and other end connected to an outlet of the disperser; and
   heat means for heating the vaporization pipe;
in which the vaporization part is adapted to heat the carrier gas including the material solution fed from the dispersion part to thereby vaporize the material solution;
wherein the disperser is provided with a radiation prevention part having a small hole outside the outlet.

### BRIEF DESCRIPTION OF THE DRAWINGS

FIG. 1 is a cross-sectional view of an essential part of an MOCVD oriented vaporizer according to an embodiment 1.

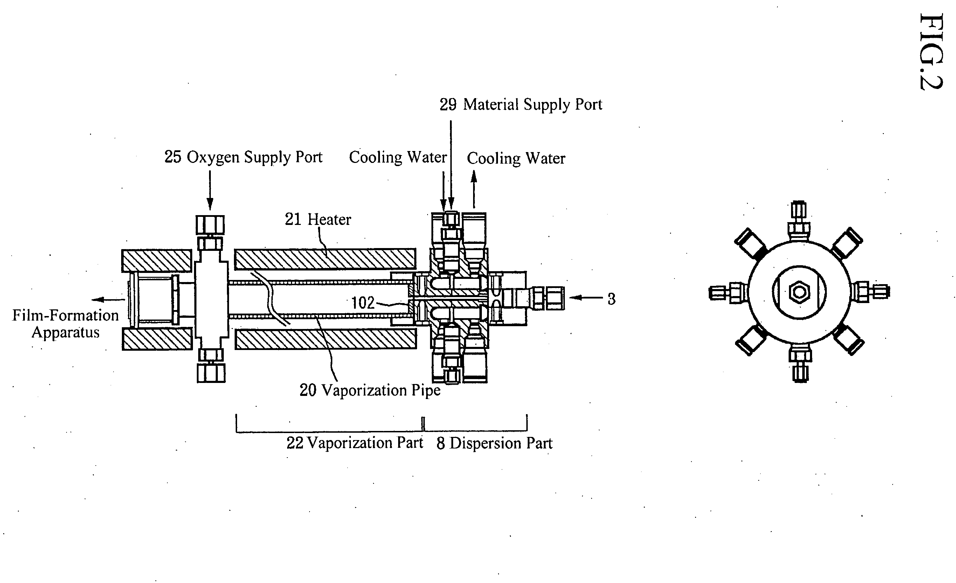

FIG. 2 is a whole cross-sectional view of the MOCVD oriented vaporizer according to the embodiment 1.

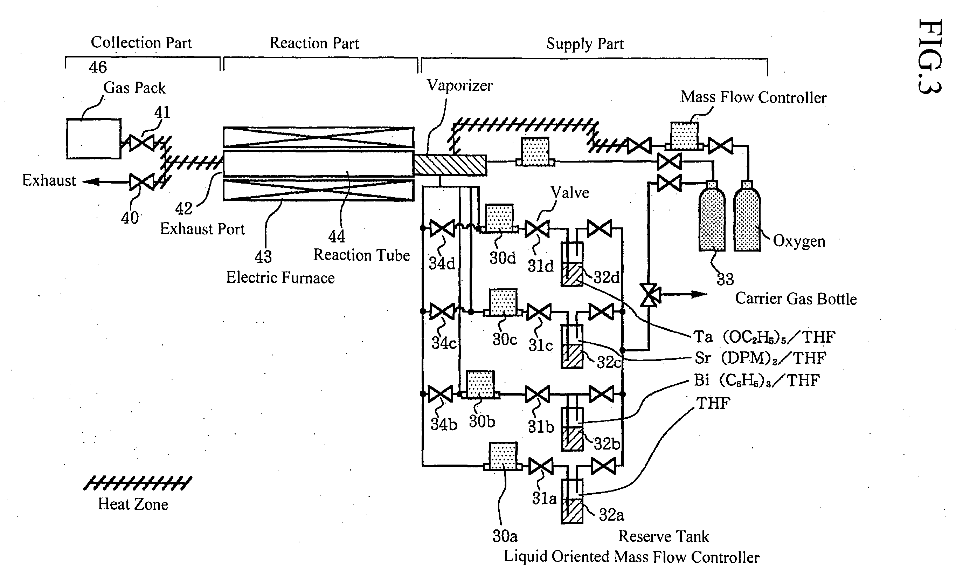

FIG. 3 is a system view of MOCVD.

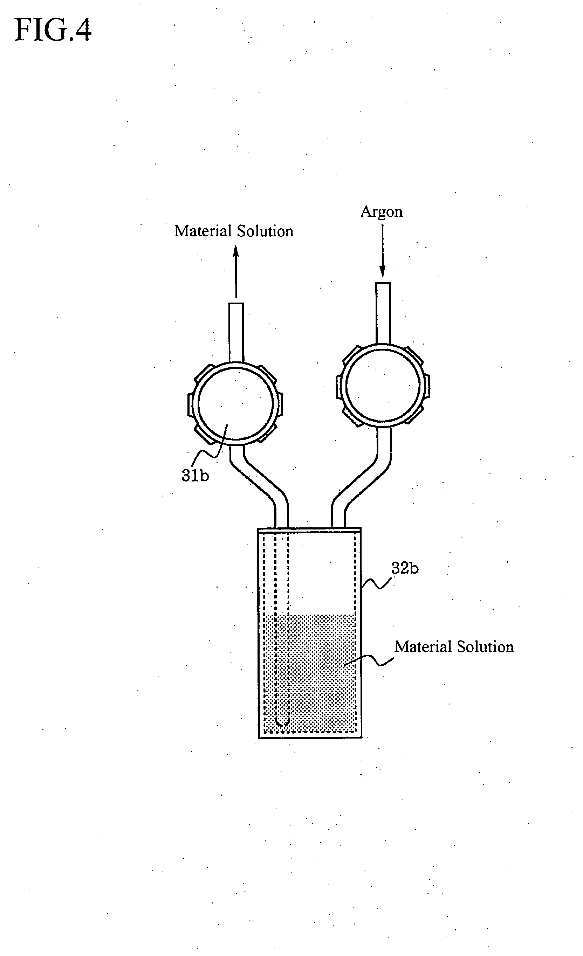

FIG. 4 is a front view of a reserve tank.

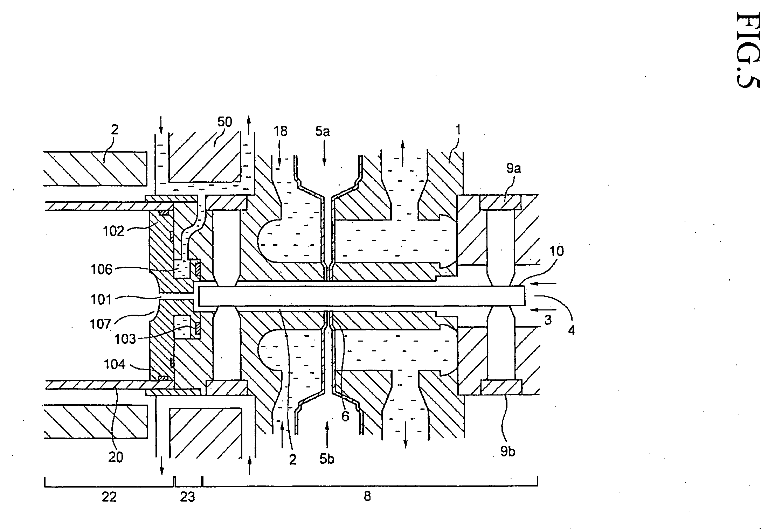

FIG. 5 is a cross-sectional view of an essential part of an MOCVD oriented vaporizer according to an embodiment 2.

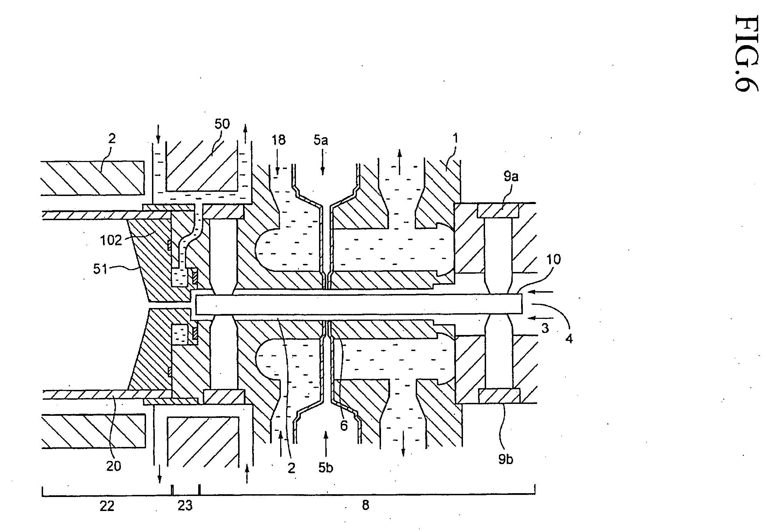

FIG. 6 is a cross-sectional view of an essential part of an MOCVD oriented vaporizer according to an embodiment 3.

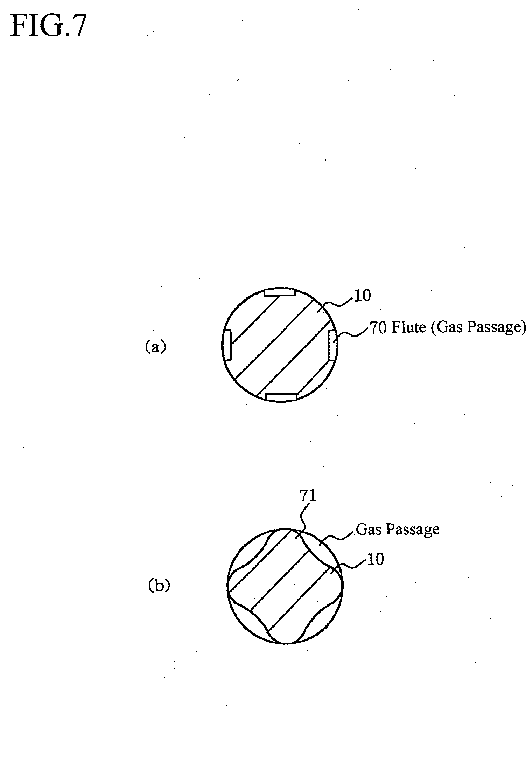

FIG. 7(a) and FIG. 7(b) are cross-sectional views according to an embodiment 4, each showing a variant of a gas passage of an MOCVD oriented vaporizer.

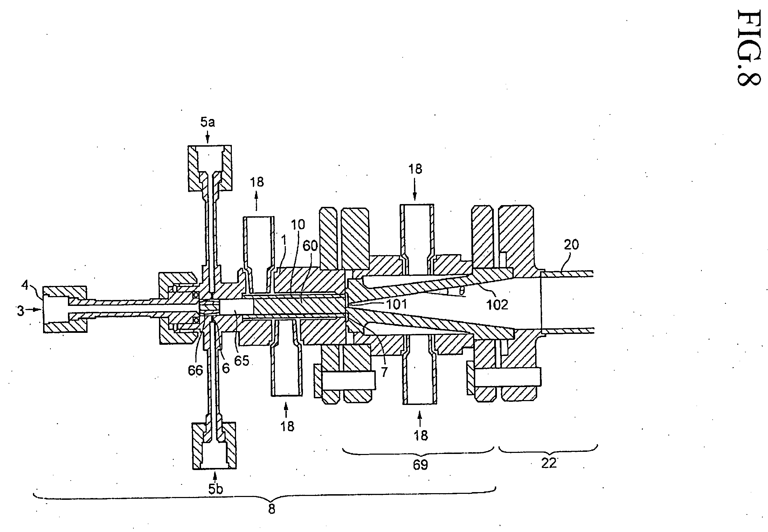

FIG. 8 is a cross-sectional view of an MOCVD oriented vaporizer according to an embodiment 5.

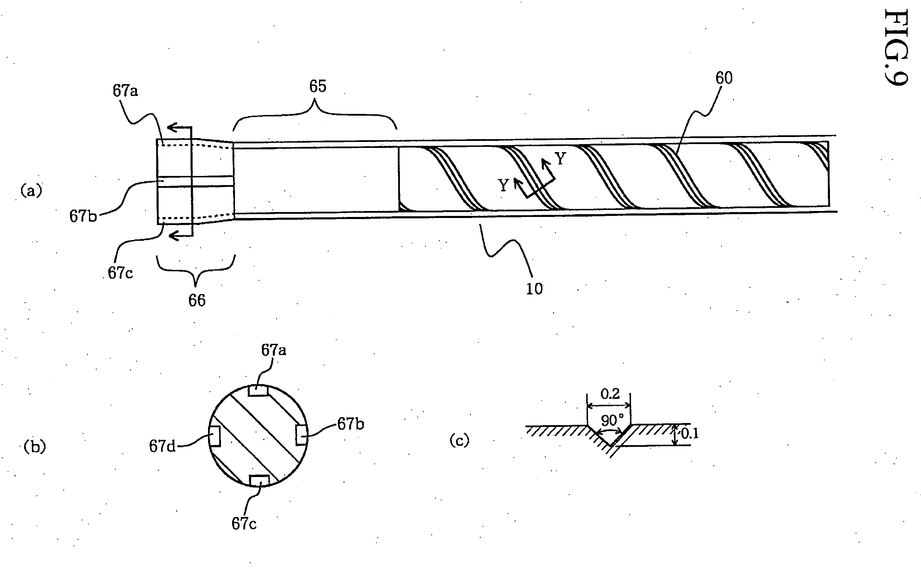

FIG. 9 shows a rod to be used for the MOCVD oriented vaporizer according to the embodiment 5, in which (a) is a side view, (b) is an X-X cross-sectional view, and (c) is a Y-Y cross-sectional view.

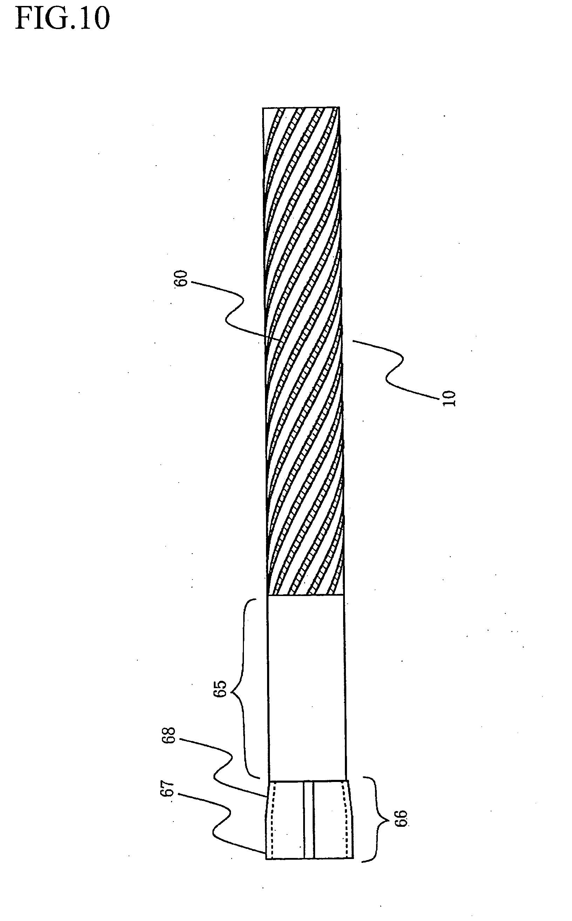

FIG. 10 is a side view of a variant of FIG. 9 (a).

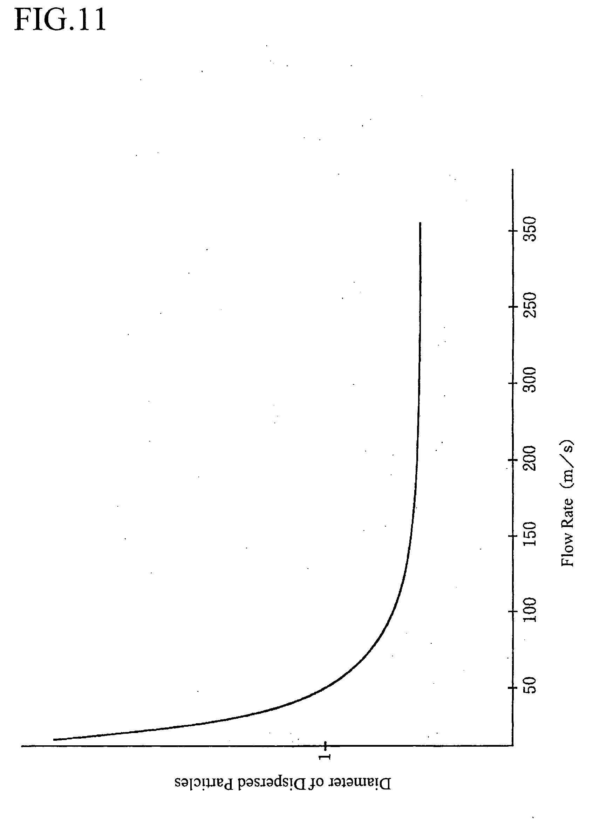

FIG. 11 is a graph of an experimental result in an embodiment 6.

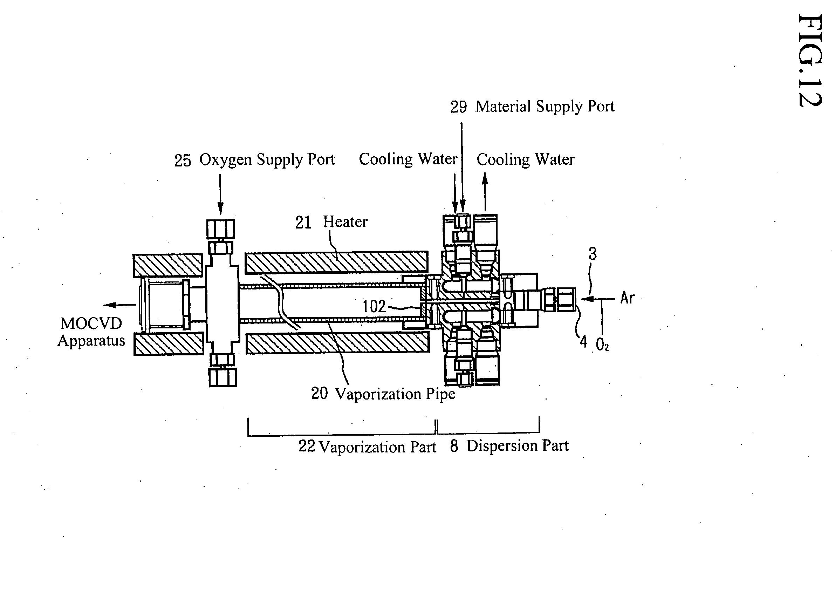

FIG. 12 is a side cross-sectional view of an embodiment 8.

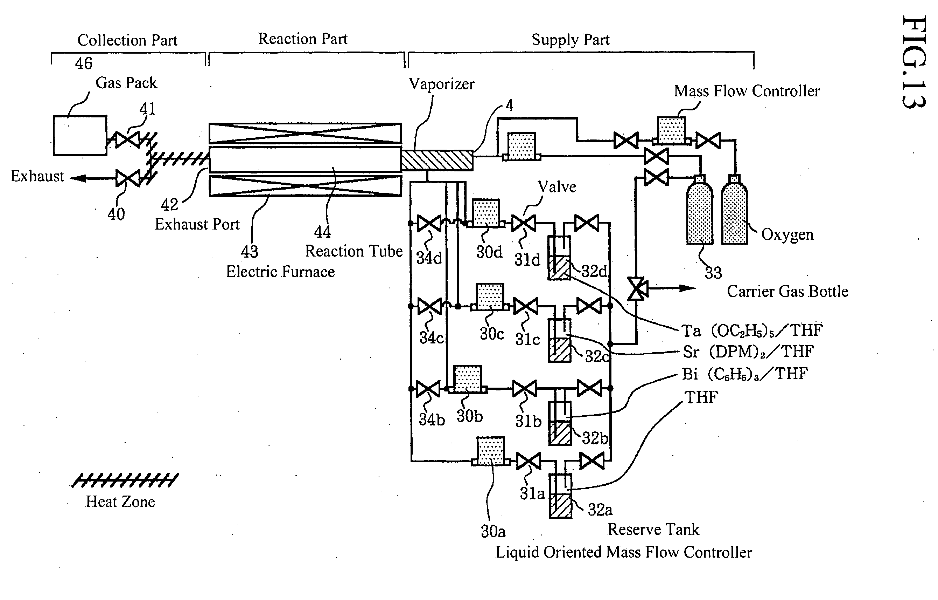

FIG. 13 is a conceptional view of a gas supply system of the embodiment 8.

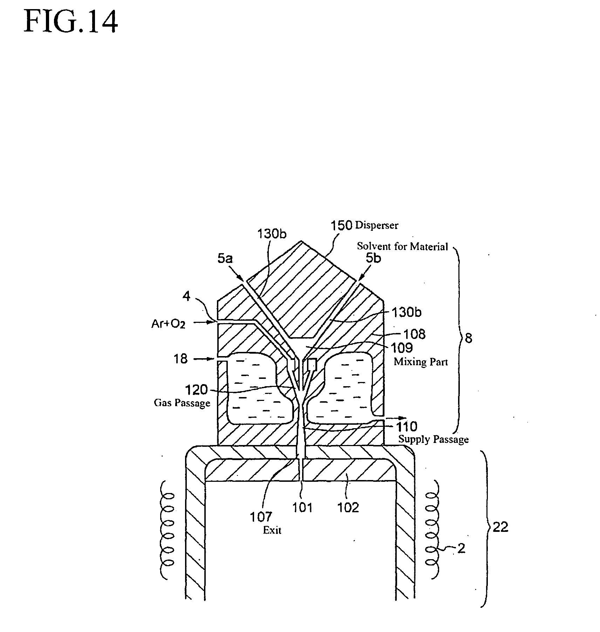

FIG. 14 is a cross-sectional view of an embodiment 9.

FIG. 15 is a cross-sectional view of the related art in the most recent time.

FIG. 16(a) and FIG. 16(b) are cross-sectional views each showing a conventional MOCVD oriented vaporizer.

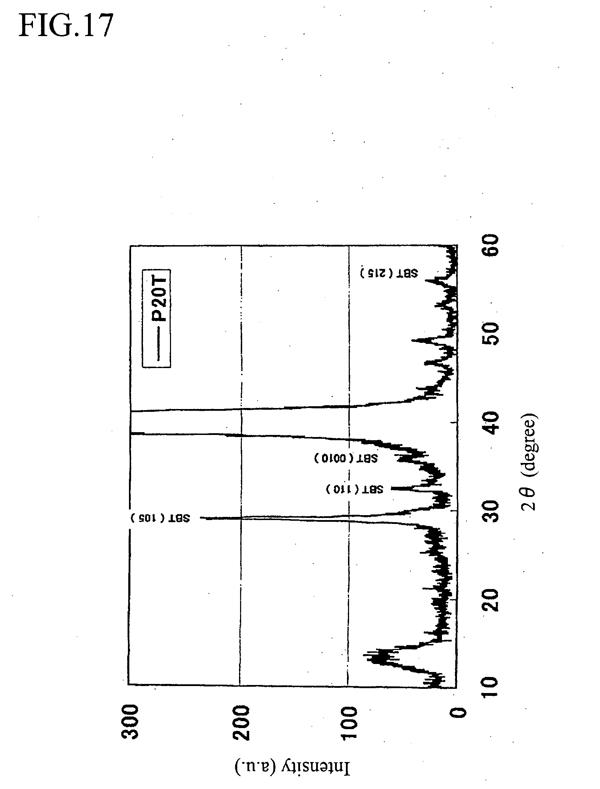

FIG. 17 is a graph of crystallization characteristic of an SBT thin-film.

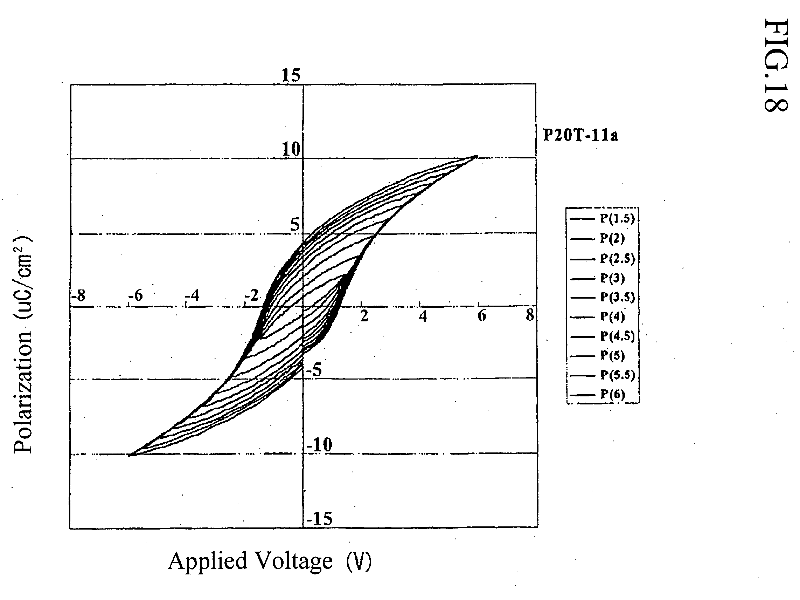

FIG. 18 is a graph of polarization characteristic of a crystallized SBT thin-film.

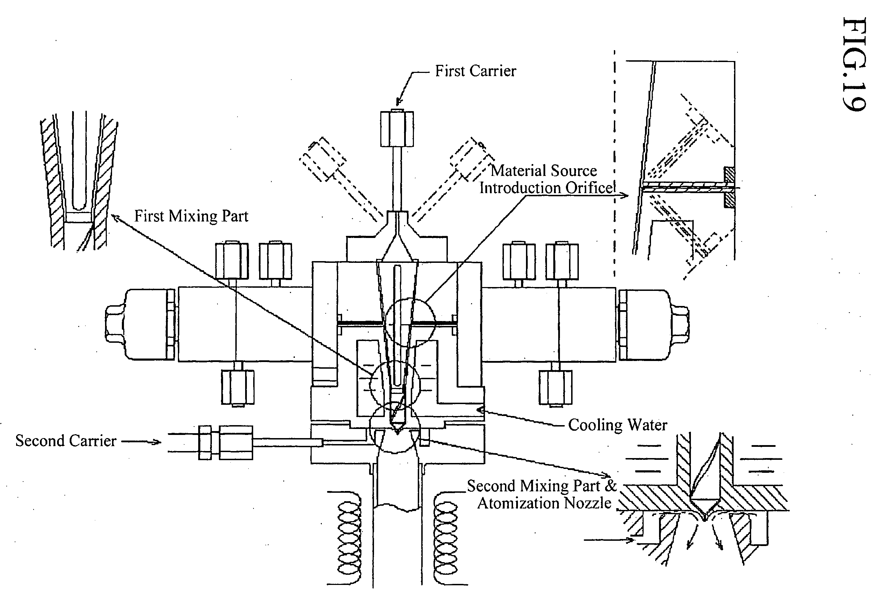

FIG. 19 is a detailed view of a vaporizer.

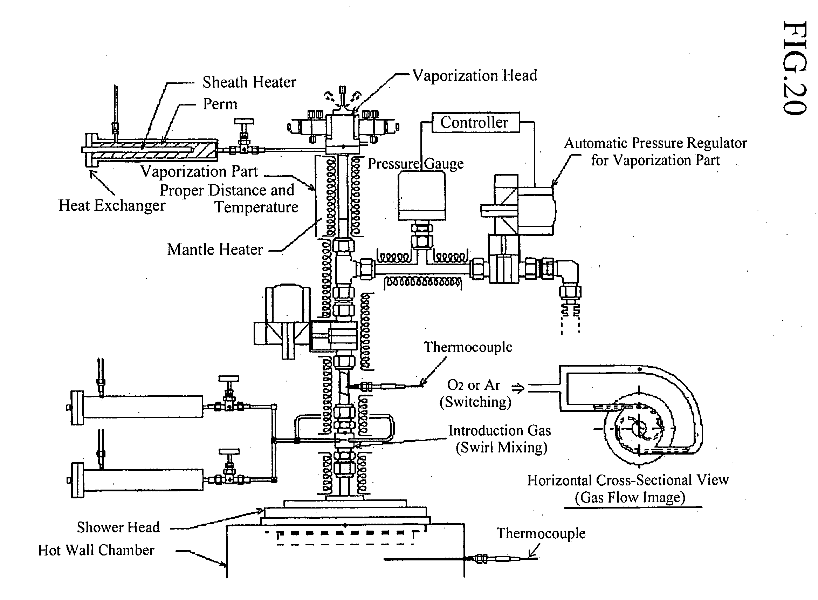

FIG. 20 is a whole view of the vaporizer.

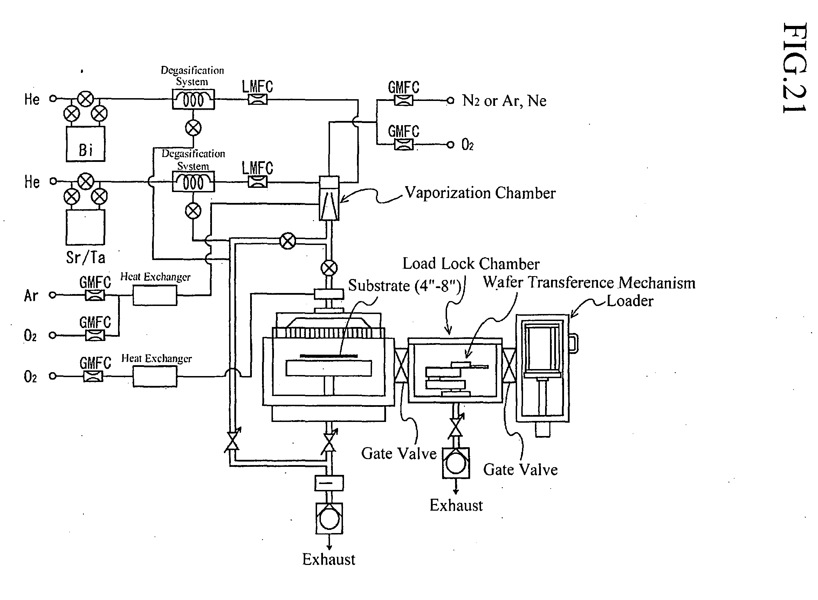

FIG. 21 is a view of an example of an SBT thin-film oriented CVD apparatus which uses a vaporizer.

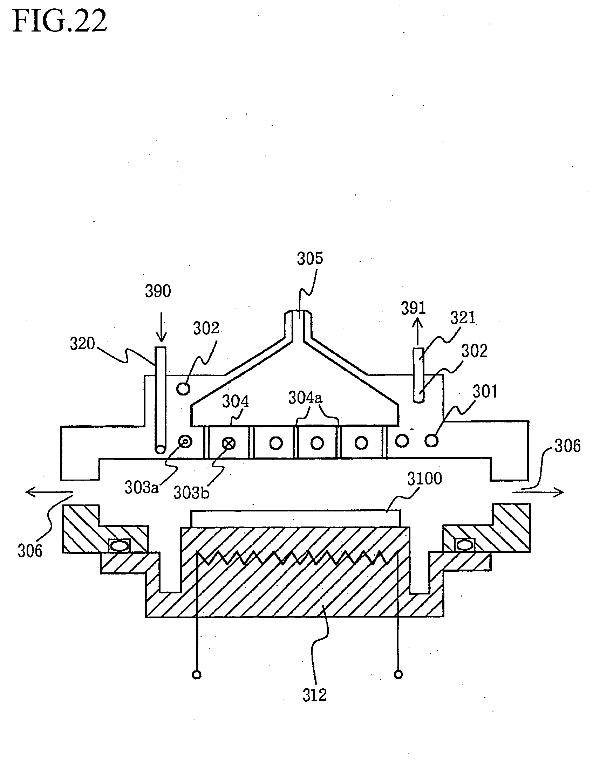

FIG. 22 is a cross-sectional view of an example of a film-formation apparatus.

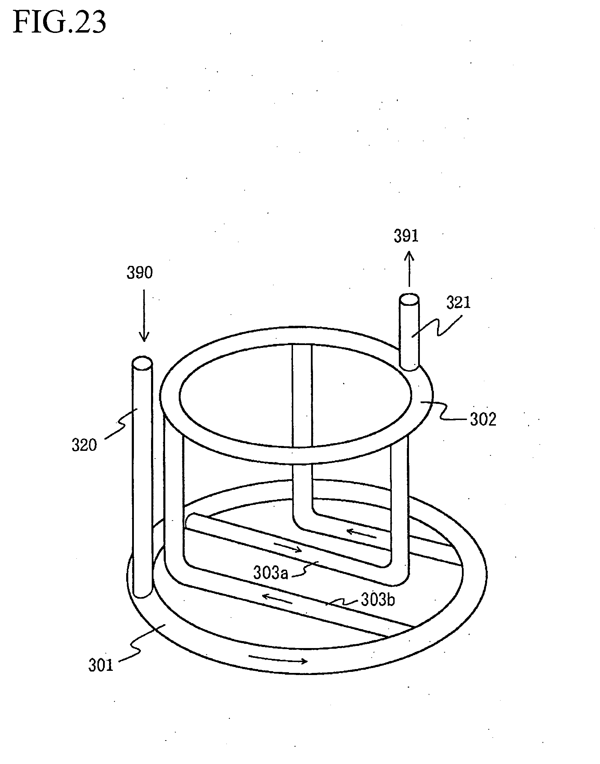

FIG. 23 is view of a formation of heat medium circulation to be used in FIG. 22.

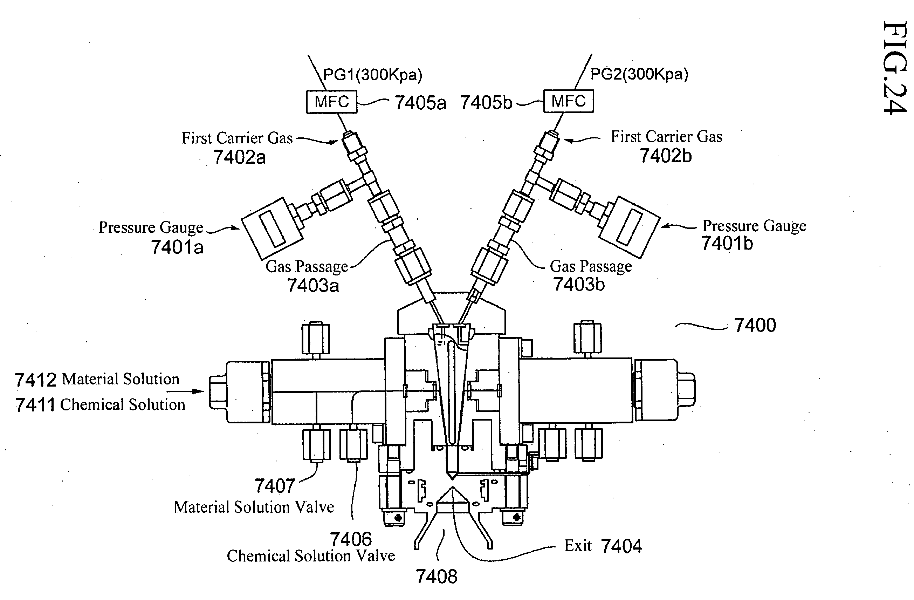

FIG. 24 is a cross-sectional view of a vaporizer according to a configuration of the present invention.

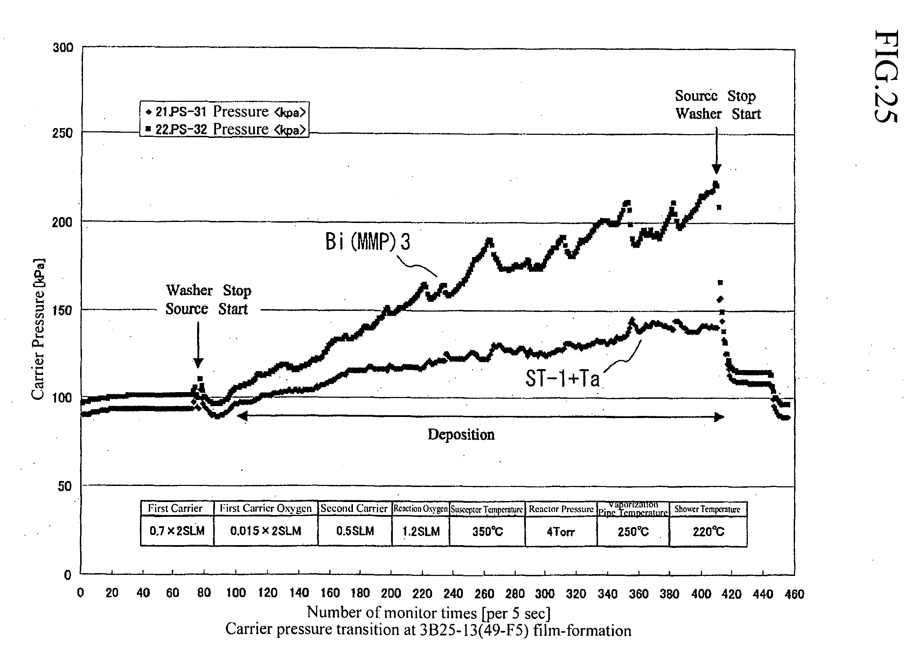

FIG. 25 is a graph of pressure transitions in gas passages of the vaporizer shown in FIG. 24.

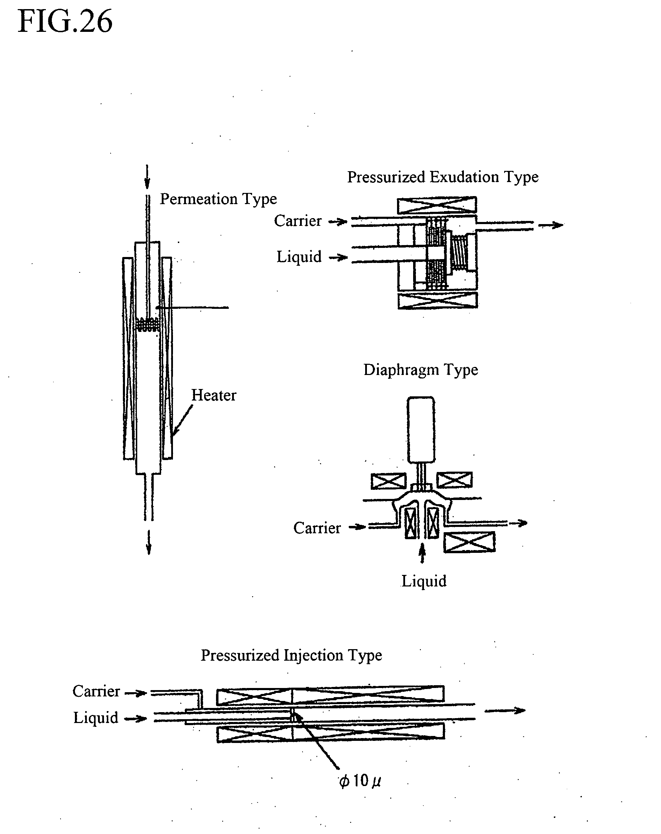

FIG. 26 is a conceptional view of vaporizer examples to which the present invention is applicable.

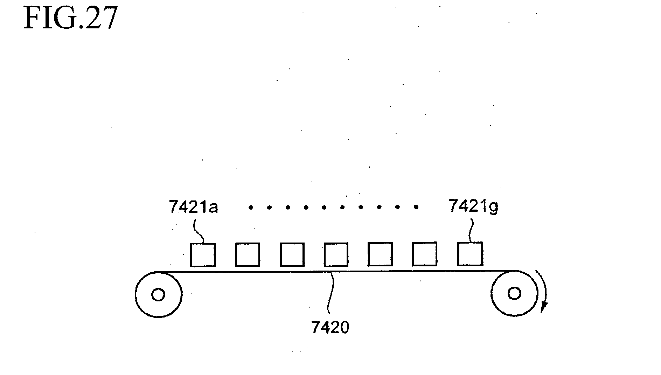

FIG. 27 is a conceptional view of a film-formation apparatus according to an embodiment 11.

### (Explanation of reference numeral)

- 1: dispersion part body
- 2: gas passage
- 3: carrier gas
- 4: gas inlet
- 5: material solution
- 6: material supply port
- 7: gas outlet
- 8: dispersion part
- 9a, 9b, 9c, 9d: screw
- 10: rod
- 18: cooling means (cooling water)
- 20: vaporization pipe
- 21: heat means (heater)
- 22: vaporizer
- 23: connection part
- 24: joint
- 25: oxygen introduction means (primary oxygen (oxidative gas) supply port)
- 29: material supply inlet
- 30a, 30b, 30c, 30d: mass flow controller
- 31a, 31b, 31c, 31d: valve
- 32a, 32b, 32c, 32d: reserve tank
- 33: carrier gas bottle
- 42: exhaust port
- 40: valve
- 44: reaction tube
- 46: gas pack
- 51: taper
- 70: flute
- 101: small hole
- 102: radiation prevention part
- 200: oxygen introduction means (secondary oxygen (oxidative gas), carrier supply port)
- 301: upstream annulus
- 302: downstream annulus
- 303a, 303b: heat transmission passage
- 304: heat conversion plate
- 304a: gas vent hole/gas nozzle
- 306: exhaust port
- 308: orifice
- 312: substrate heater
- 320: heat medium inlet
- 321: heat medium outlet
- 390: entering heat medium
- 391: exiting heat medium
- 3100: silicon substrate

### BEST MODE FOR CARRYING OUT THE INVENTION

FIG. 24 shows a configuration of the present invention.

Note that FIG. 24 shows a vaporizer obtained by providing a vaporizer shown in FIG. 19 with an MFC and pressure detection means (pressure gauges).

This configuration comprises a vaporizer 7400 configured to introduce carrier gases 7402a, 7402b from one ends of gas passages 7403a, 7403b, respectively, and to feed the carrier gas including material solutions from the cooperative other end (outlet) 7404 of the gas passages 7403a, 7403b to a vaporization part 7405 to thereby vaporize the material solutions, in which the vaporizer is provided with: mass flow controllers (MFC's) 7405a, 7405b at one ends of the gas passages 7403a, 7403b, respectively; and pressure gauges 7401a, 7401b as means for detecting pressures within the gas passages 7403a, 7403b, respectively.

Conventionally, there has been adopted a decrease in film thickness after film formation, as a clue for knowing occurrence and progression of clogging in the outlet 7404. Namely, it has been considered that clogging is judged to be caused at the time of commencement of decrease in film thickness in case of film formation based on a constant film formation time per substrate. However, reasons leading to decrease in film thickness are not limited to clogging. It is thus often that clogging has not been caused even when the applicable apparatus is disassembled at the time of decrease in film thickness.

The present inventors have carefully observed a situation of occurrence of clogging, and found that occurrence of clogging brings about a pressure transition within a gas passage. As such, it becomes possible to know a time point where washing of deposited matters and the like is required, by controlling a pressure within the gas passage by an MFC and detecting the pressure within the gas passage.

It is particularly possible to eliminate deposited matters and the like without disassembling the apparatus, by providing means for introducing: a chemical solution 7411 capable of dissolving therein the deposited matters and the like within the gas passages 7403a, 7403b; into the gas passages 7403a, 7403b. Namely, the present inventors have found that introduction of the chemical solution 7411 allows for elimination of deposited matters and the like in an extremely easy manner and within a short time. Further, it is possible to know a termination point of washing, by detecting the pressures within the gas passages 7403a, 7403b by the pressure gauges 7401a, 7401b, respectively, even during washing by the chemical solution 7411.

Note that it is possible to use a solvent of a material solution 7412, as the chemical solution 7411.

Further, it is desirable that the cooperative other end (outlet) 7404 of the gas passages 7403a, 7403b is smaller in diameter than other portions of the gas passages. Not larger than 2mm in diameter is particularly desirable. Smaller outlets in diameter enable more sensitive detection of pressure transitions within the gas passages 7403a, 7403b with respect to deposition or sticking of matters and the like.

Note that it is possible to easily know a time point where washing is required, by providing an arrangement that signals obtained by the pressure detection means 7401a, 7401b are displayed on an external monitor.

Further, it is desirable to control: each material solution valve 7407 configured to conduct ON and OFF of supply of an applicable material solution; and each chemical solution valve 7406 for conducting ON and OFF of supply of the chemical solution; based on the signals obtained by the pressure detection means 7401a, 7401b. Namely, there is conducted such automatic control that the material solution valves 7407 are closed when the pressures within the gas passages 7403a, 7403b are increased to constant values, respectively, to thereby open each chemical solution valves 7406. Also, there is conducted such automatic control that the material solution valves 7407 are opened when the pressures within the gas passages 7403a, 7403b are decreased to constant values upon washing, respectively, to thereby close each chemical solution valve 7406.

Carrier gases were introduced into the MFC's 7405a, 7405b at pressures of 300kPa, and the pressures for the gas passages 7403a, 7403b were set at 100kPa.

Film formation was conducted for each ferroelectric material Bi(MMP)3 and PZT. Each film formation was started by stopping supply of chemical solution and starting supply of material solutions, as shown in FIG. 25. Note that FIG. 25 shows an upper line for Bi(MMP)3 and a lower line for PZT.

Bi(MMP)3 was supplied at 0.2ccm and PZT was supplied at 0.1ccm.

Pressures within the gas passages 7403a, 7403b were measured by the pressure gauges 7401a, 7401b, respectively, and the measured data were displayed as digital data on a monitor.

The initial pressure was 100kPa. Other conditions for vaporization and film-formation are shown in Table in FIG. 25.

After about 35 minutes, Bi(MMP)3 reached 225kPa, and PZT reached 150kPa. At that time, the applicable material solutions were stopped, and supply of the applicable chemical solution was started.

As shown in FIG. 25, pressures within the gas passages 7403a, 7403b were returned to 100kPa, within an extremely short time from the start of chemical solution supply.

Although the carrier gases were introduced at two locations in the example shown in FIG. 24, the above description is also applicable to a situation where the carrier gas is introduced at one location. This is also true for three or more locations.

There will be described various vaporizers and film-formation apparatuses adopting such vaporizers in the following embodiments, and there have been obtained the results for these vaporizers and film-formation apparatuses in the same tendencies as that shown in FIG. 25 by providing the above described MFC's and pressure gauges, respectively.

### Embodiments

### (Embodiment 1)

FIG. 1 shows an MOCVD oriented vaporizer according to an embodiment 1.

This embodiment has:
(i) a dispersion part 8 including:
   a gas passage 2 formed within a dispersion part body 1 constituting the dispersion part,
   a gas inlet 4 for introducing a pressurized carrier gas 3 into the gas passage 2,
   means (material supply ports) 6 for supplying material solutions 5 into the carrier gas passing through the gas passage 2, to thereby atomize the material solutions 5 into a mist state,
   a gas outlet 7 for feeding the carrier gas including the material solutions 5 in the mist state (i.e., a material gas) to a vaporization part 22, and
   means (cooling water) 18 for cooling the carrier gas flowing through the gas passage 2; and
(ii) the vaporization part 22 including:
   a vaporization pipe 20 having one end connected to a reaction tube of an MOCVD apparatus, and the other end connected to the gas outlet 7 of the dispersion part 8, and
   heat means (heater) 21 for heating the vaporization pipe 20,
   so that the carrier gas including the material solutions dispersed therein and fed from the dispersion part 8, is heated to vaporize the material solutions;
wherein there is provided a radiation prevention part 102 having a small hole 101 outside the gas outlet 7.

This embodiment will be explained hereinafter in more detail.

In the embodiment shown in the figure, the dispersion part body 1 has a cylindrical hollow inside it. Fitted in the hollow is a rod 10 such that the gas passage 2 is defined between an inner wall of the dispersion part body and the rod 10. Note that the hollow may be in another shape, without limited to the cylindrical shape. Preferable is a conical shape, for example. As an angle for a cone of the conical hollow, 0 to 45° is preferable, and 8 to 20° is more preferable. This is also applicable to other embodiments.

Note that the gas passage preferably has a cross-sectional area of 0.10 to 0.5mm². Cross-sectional areas smaller than 0.10mm² lead to difficult machining. Cross-sectional areas exceeding 0.5mm² cause a necessity for using a large amount of carrier gas at a high pressure so as to bring the carrier gas to a high speed.

Further, usage of the large amount of carrier gas requires a large-sized vacuum pump of a larger capacity so as to keep a reaction chamber at a decreased pressure (1.0 Torr, for example). Since it is difficult to employ a vacuum pump having a piston displacement exceeding 10,000 liters/min (at 1.0 Torr), suitable flow rates, i.e., suitable gas passage area of 0.10 to 0.5MM² are preferable for contemplating practical use in an industrial manner.

Provided at one end of the gas passage 2 is the gas inlet 4. Connected to the gas inlet 4 is a source (not shown) of carrier gas (such as N₂, Ar, He).

Provided at sides of a substantial center of the dispersion part body 1, are material supply ports 6 in a manner to be communicated with the gas passage 2, so that the material solutions 5 can be introduced into the gas passage 2 to thereby disperse the material solutions 5 into the carrier gas passing through the gas passage 2, thereby preparing a material gas.

Provided at one end of the gas passage 2 is the gas outlet 7 communicated with the vaporization pipe 20 of the vaporization part 22.

The dispersion part body 1 is formed with spaces 11 for flowing cooling water 18 therethrough, in a manner to cool the carrier gas flowing through the gas passage 2, by flowing the cooling water 8 through the spaces. Alternatively, it is possible to provide a Peltier element or the like for cooling, in the space. Since the inside of the gas passage 2 of the dispersion part 8 is affected by heat of the heater 21 of the vaporization part 22, there is typically caused vaporization of solvents only of the material solutions, without achieving simultaneous vaporization of the solvents and organometallic complexes of the material solutions within the gas passage 2. As such, there is avoided vaporization of the solvents only, by cooling the carrier gas flowing through the gas passage 2 and including the material solutions dispersed therein. It is particularly important to cool the downstream of the material supply ports 6 so that at least the downstream of the material supply ports 6 is cooled. Cooling temperature is to be at or lower than a boiling point of an applicable solvent. For example, it is 67°C or lower in case of THF. Particularly, the temperature at the gas outlet 7 is important.

Further, this embodiment is provided with the radiation prevention part 102 having the small hole 101 outside the gas outlet 7. Note that reference numerals 103, 104 represent seal members such as O-rings or the like. The radiation prevention part 102 may be made of teflon, stainless steel, ceramics or the like, for example. Namely, this part is preferably made of a material excellent in thermal conductivity.

According to the knowledge of the present inventors, heat in a vaporization part acts as radiant heat which passes through the gas outlet 7 to overheat the gas within the gas passage 2 insofar as in the related art. As such, those components in the gas which have lower melting points are caused to be deposited near the gas outlet 7, even when cooled by the cooling water 18.

The radiation prevention part is provided for preventing such radiant heat from propagating to the gas. It is thus preferable that the cross-sectional area of the small hole 101 is set to be smaller than that of the gas passage 2. Setting of 1/2 or smaller is preferable, and setting of 1/3 or smaller is more preferable. Further, it is desirable to provide the small hole in a micro size. Particularly, it is desirable to provide it in such a micro size to eject the gas at a subsonic flow rate.

The small hole has a length which is preferably 5 or more times, and more preferably 10 or more times, the size of the small hole, itself.

Further, cooling the dispersion part avoids occurrence of occlusion within the gas passage (particularly the gas outlet) due to carbides, even for usage over a long period of time.

The dispersion part body 1 is connected to the vaporization pipe 20, at a downstream side of the dispersion part body 1. The connection between the dispersion part body 1 and vaporization pipe 20 is achieved by a joint 24, and this part acts as connection part 23.

FIG. 2 is a whole cross-sectional view. The vaporization part 22 is configured with the vaporization pipe 20 and the heat means (heater) 21. The heater 21 is provided for heating the carrier gas flowing within the vaporization pipe 20 and including material solutions dispersed therein, thereby vaporizing the material solutions. For the heater 21, although the conventional one has been constituted by attaching a cylindrical heater or mantle heater to an outer periphery of the vaporization pipe 20, the most excellent way is to adopt such a liquid or gas as a heat medium, which has a larger heat capacity, so as to heat the vaporization pipe such that the same is brought to have a uniform temperature along the longitudinal direction of the vaporization pipe itself, and thus such a way is adopted.

As the vaporization pipe 20, it is desirable to employ stainless steel such as SUS316L, for example. While the dimension of the vaporization pipe 20 is to be appropriately determined to be such a length that the vaporizedly obtained gas is sufficiently heated to a due temperature, it is exemplarily preferable to employ a vaporization pipe having an outer diameter of 3/4 inch and a length of several hundreds mm in case of vaporizing a material solution of SrBi₂Ta₂O₉ at 0.04ccm.

The vaporization pipe 20 has its downstream end side connected to a reaction tube of an MOCVD apparatus, and the vaporization pipe 20 of this embodiment is provided with oxygen supply ports 25 as oxygen supply means so that oxygen heated to a predetermined temperature can be mixed into the carrier gas.

There will be firstly explained supply start to the vaporizer.

As shown in FIG. 3, the material supply ports 6 are connected with reserve tanks 32a, 32b, 32c, 32d, through mass flow controllers 30a, 30b, 30c, 30d and valves 31a, 31b, 31c, 31d, respectively.

Further, the reserve tanks 32a, 32b, 32c, 32d are connected to a carrier gas bottle 33.

FIG. 4 shows details of the reserve tank.

The pertinent reserve tanks are each filled with a material solution, and each reserve tank (inner volume of 300cc, and made of SUS) is fed with a carrier gas (such as inert gas Ar, He, Ne) at 1.0 to 3.0kgf/cm², for example. The inside of each reserve tank is pressurized by the carrier gas, so that the associated material solution is pushed up through an inside of a pipe contacting with the material solution and pumped up to the associated liquid oriented mass flow controller (manufactured by STEC, full scale flow rate of 0.2cc/min), by which the flow rate is controlled, and the material solution is transported from an associated material supply inlet 29 of the vaporizer to the associated material supply port 6 of the vaporizer.

They are transported to the reaction part by the carrier gas controlled to have a constant flow rate by its associated mass flow controller. Simultaneously, oxygen (oxidizing agent) is also transported to the reaction part, the oxygen being controlled to have a constant flow rate by an associated mass flow controller (manufactured by STEC, full scale flow rate of 2L/min).

Each material solution is provided by dissolving organometallic complex, which is liquid or solid at an ordinary temperature, in THF solvent or any other solvent, so that when the material solution is left as it is, the THF solvent evaporates to cause deposition of the organometallic complex which is eventually brought into a solid state. It is thus supposed that a pipe contacting with the material solution is brought to be occluded due to such a solid matter. As such, there are provided washing lines, based on such a consideration that it is enough to wash insides of the pipes and vaporizer after termination of film-formation task, for restricting occlusion of the pipes. The washing is to be conducted for a zone from material containers to the vaporizer in a manner to wash out, by solvents, those parts applicable to the tasks including a task for exchanging the material containers.

The carrier gas was pumped into the reserve tanks 32b, 32c, 32d, while opening the valves 31b, 31c, 31d. Each material solution is pumped up to the associated mass flow controller (manufactured by STEC, full scale flow rate of 0.2cc/min) where the flow rate is controlled, so that the material solution is transported to the associated material supply port 6 of the vaporizer.

Meanwhile, the carrier gas was introduced from the gas inlet of the vaporizer. It is desirable that the maximum pressure at the inlet side is set at 3kgf/cm² or lower, in which the maximum flow rate allowed to pass therethrough is about 1,200cc/min so that the flow rate through the gas passage 2 reaches one hundred and several tens m/s.

As the material solutions from the material supply ports 6 are introduced into the carrier gas flowing through the gas passage 2 of the vaporizer, the material solutions are sheared by the high-speed flow of the carrier gas and brought into ultra-fine particles. As a result, the material solutions are dispersed into the carrier gas, in a state of ultra-fine particles. The carrier gas including the material solutions in the state of ultra-fine particles (i.e., the material gas) still kept at the high-speed, is atomized and ejected into the vaporization part 22. There is optimized an angle defined between the gas passage and each material supply port. When the carrier flow passage and each material solution inlet define therebetween an acute angle (30°), the solution is drawn by the gas. At 90° or larger, each solution is pushed by the gas. The optimum angle is determined based on a viscosity and a flow rate of the applicable solution. Even in case of a larger viscosity and a larger flow rate, the applicable solution is caused to flow smoothly by adopting an acuter angle. In case of formation of SBT film by adopting hexane as a solvent, about 84° is desirable since the viscosity and flow rate are both low.

The three kinds of material solutions each controlled to have a constant flow rate, flow into the gas passage 2 through the associated material supply inlets 29 and material supply ports 6, respectively, and are moved through the gas passage together with the carrier gas having brought to a high-speed, and then ejected into the vaporization part 22. Also at the dispersion part 8, the material solutions are heated by heat from the vaporization part 22 and the solvents such as THF are promoted in evaporation, so that the zones from the material supply inlets 29 to the material supply ports 6 and the zone of the gas passage 2 are cooled by cooling medium such as water.

The material solutions dispersed in the carrier gas in the state of fine particles and ejected from the dispersion part 8, are promoted in vaporization during transportation through the inside of the vaporization pipe 20 heated to a predetermined temperature by the heater 21, and are then brought into a mixed gas by mixture of oxygen heated to a predetermined temperature from the oxygen supply port 25 provided just prior to reaching a reaction tube for MOCVD, such that the mixed gas flows into the reaction tube. Note that evaluation is achieved in this embodiment, by analyzing a reaction manner of the vaporizedly obtained gas instead of film-formation.

Connected to an exhaust port 42 is a vacuum pump (not shown), and there was conducted an operation for reducing the pressure for about 20 minutes to remove impurities such as water within the reaction tube 44, and a valve 40 downstream of the exhaust port 42 was closed.

Cooling water was flowed through the vaporizer at a rate of about 400cc/min. Meanwhile, there was flown a carrier gas at a rate of 495cc/min by a pressure of 3kgf/cm² to thereby sufficiently fill the inside of the reaction tube 44, and then the valve 40 was opened. The temperature at the gas outlet 7 was lower than 67°C. The inside of the vaporization pipe 20 was heated to 200°C, the zone from the reaction tube 44 to a gas pack 46 and the gas pack itself to 100°C, and the inside of the reaction tube 44 to 300°C to 600°C.

The insides of the reserve tanks were pressurized by the carrier gas, and the predetermined liquids were flown by the associated mass flow controllers, respectively.

Sr (DPM)₂, Bi (C₆H₅) ₃, Ta(OC₂H₅)₅, and THF were flown at flow rates of 0.04cc/min, 0.08cc/min, 0.08cc/min, and 0.2cc/min, respectively.

After 20 minutes, there was opened a valve just prior to the gas pack 46 to thereby collect a reaction product into the gas pack 46, which was analyzed by gas chromatography, thereby checking whether or not the detected product corresponded to a product to be given by a reaction formula considered based on a reaction theory. As a result, the detected product satisfactorily corresponded to the product to be given by the reaction formula considered based on the reaction theory, in this embodiment.

There was further measured a sticked amount of carbides at an outer surface at the gas outlet 7 side of the dispersion part body 1. As a result, the sticked amount of carbides was very small, and it was further decreased by using an apparatus shown in FIG. 14.

Note that when metal as a film material is mixed or dissolved in a solvent to establish a material solution, it is typical that the metal becomes complex so that the material solution is brought into a liquid/liquid state (complete solvent liquid). However, the present inventors have carefully studied a material solution, and found that metal complexes are not necessarily brought into a separated molecule state such that metal complexes themselves may be present as fine particles of sizes of 1 to 100nm in the solvent, so that the material solution may be present partially in a solid/liquid state. Although it is considered that clogging upon vaporization tends to be caused particularly in case of the material solution in a solid/liquid state, clogging is never caused for a material solution even in such a state insofar as the vaporizer of the present invention is used.

Further, in a stored material solution, fine particles tend to precipitate at a bottom portion of the solution, due to the gravity to the fine particles. As such, it is desirable from a standpoint of prevention of clogging, to uniformly disperse fine particles in a stored solution by heating a bottom portion of the solution (absolutely to a temperature below an evaporation point of the solvent) to thereby cause convection within the solution, for uniform dispersion of fine particles. It is also desirable to cool an upper side of the container while heating the bottom portion. The heating is of course conducted at a temperature below the evaporation temperature of the solvent.

Note that it is desirable that the heater is set or controlled such that a heating calorie for an upper region of the vaporization pipe is larger than a heating calorie for a downstream region of the same. Namely, the heater is desirably set or controlled to provide a large heating calorie for the upper region of the vaporization pipe and a small heating calorie for the downstream region of the same, since the water-cooled gas is ejected from the dispersion part.

### (Embodiment 2)

FIG. 5 shows an MOCVD oriented vaporizer according to an embodiment 2.

In this embodiment, the radiation prevention part 102 is formed at its outer periphery with a cooling water passage 106, and the connection part 23 is provided with cooling means 50 for cooling the radiation prevention part 102.

Further, there is provided a recess 107 around the small hole 101.

Other aspects are the same as those of the embodiment 1.

In this embodiment, there was found a more satisfactory correspondence between the detected product and the product to be given by the reaction formula considered based on the reaction theory, than the case of the embodiment 1.

Further, as a result of measurement of a sticked amount of carbides at an outer surface at the gas outlet 7 side of the dispersion part body 1, the sticked amount of carbides was about 1/3 times that in the case of the embodiment 1.

### (Embodiment 3)

FIG. 6 shows an MOCVD oriented vaporizer according to an embodiment 3.

In this embodiment, the radiation prevention part 102 is provided with a taper 51. Such a taper eliminates a dead zone there, to enable prevention of retention of materials.

Other aspects are the same as those of the embodiment 2.

In this embodiment, there was found a more satisfactory correspondence between the detected product and the product to be given by the reaction formula considered based on the reaction theory, than the case of the embodiment 2.

Further, as a result of measurement of a sticked amount of carbides at an outer surface at the gas outlet 7 side of the dispersion part body 1, the sticked amount of carbides was nearly absent.

### (Embodiment 4)

FIG. 7 shows a modified embodiment of the gas passage.

In FIG. 7(a), the rod 10 is formed with flutes 70 at its surface, and the rod 10 is constituted to have an outer diameter which is substantially the same as an inner diameter of a through-hole formed in the dispersion part body 1. This allows for the rod 10 to be arranged within the through-hole without any eccentricity, by simply fitting the rod 10 into the through-hole. It is also unnecessary to use a screw or the like. The flutes 70 cooperatively act as the gas passage.

Note that although the flutes 70 may be plurally formed in a manner parallel to a longitudinal central axis of the rod 10, the flutes may be spirally formed on the surface of the rod 10. In the case of spiral, there can be obtained a material gas which is more excellent in uniformity.

FIG. 7(b) shows an example where the rod 10 is provided with a mixing part at an end portion of the rod 10. The end portion has its maximum diameter which is set to be substantially the same as an inner diameter of the through-hole formed in the dispersion part body 1. The rod end portion and the inner surface of the through-hole define therebetween a space serving as a gas passage.

Note that although the examples shown in (a), (b) each include the worked surface of the rod 10, it is of course possible to employ a rod having a circular cross-section and to provide the through-hole with recesses cooperatively serving as the gas passage. Further, it is desirable to conduct installation of the rod with a tolerance on the order of H7xh6 to JS7 specified by JIS.

### (Embodiment 5)

There will be explained an embodiment 5 based on FIG. 8.

The MOCVD oriented vaporizer of this embodiment has:
(i) a dispersion part 8 including:
   a gas passage formed therein,
   a gas inlet 4 for introducing a pressurized carrier gas 3 into the gas passage,
   means for supplying material solutions 5a, 5b into the gas passage,
   a gas outlet 7 for feeding the carrier gas including the material solutions 5a, 5b, to a vaporization part 22; and
(ii) a vaporization part 22 including:
   a vaporization pipe 20 having one end connected to a reaction tube of an MOCVD apparatus and the other end connected to the gas outlet 7, and
   heat means for heating the vaporization pipe 20;
   so that the carrier gas including the material solutions fed from the dispersion part 8, is heated to vaporize the material solutions;
wherein the dispersion part 8 has a dispersion part body 1 having a cylindrical hollow therein, and a rod 10 having an outer diameter smaller than an inner diameter of the cylindrical hollow;
the rod 10 has one or two or more spiral flutes 60, on an outer periphery of the rod and at the vaporization part 22 side;
the rod 10 is inserted in the cylindrical hollow; and
there is provided, outside the gas outlet 7, a radiation prevention part 101 which has a small hole 101 and has an inner diameter widened in a taper shape toward the vaporization part 22 side.

When the material solutions 5 are supplied into the gas passage including the high-speed carrier gas 3 flowing therethrough, the material solutions are sheared and atomized. Namely, the material solutions consisting of liquids are sheared by the high-speed flow of carrier gas and brought into particles. The material solutions brought into particles are dispersed in the carrier gas, in the particle state. This aspect is the same as the embodiment 1.

Note that the following conditions are desirable for optimized shearing and atomizing.

Supply of the material solutions 5 are conducted, preferably at a rate of 0.005 to 2cc/min, more preferably 0.005 to 0.02cc/min, most preferably 0.1 to 0.3cc/min. This applies to a total amount, when a plurality of material solutions (including solvents) are simultaneously supplied.

Further, the carrier gas is supplied, preferably at a rate of 10 to 200 m/sec, and more preferably 100 to 200 m/sec.

Since there is an interrelation between a material solution flow and a carrier gas flow, there are of course selected a cross-sectional area and a shape of a flow passage by which optimum shearing and atomizing can be realized to obtain an ultra-fine particle mist.

In this embodiment, the rod 10 is formed at its outer periphery with the spiral flute(s) 60, and there is a clearance space between the dispersion part body 1 and the rod 10, so that the carrier gas including material solutions in atomized states straightly advances as straight flows through the clearance space while forming spiral flows along the flute(s) 60.

The present inventors have found that the atomized material solutions in such a state, where straight flows and spiral flows are simultaneously present, are uniformly dispersed in the carrier gas. Although it is not necessarily clear as to why such uniform dispersion can be obtained when straight flows and spiral flows are simultaneously present, this is considered as follows. Presence of spiral flows causes a centrifugal force acting on the main flows, thereby causing a secondary flow. This secondary flow promotes mixing of materials and carrier gas. Namely, it is considered that the centrifugal effect of the spiral flows causes a secondarily derived flow in a direction perpendicular to the main flows, so that the atomized material solutions are uniformly dispersed in the carrier gas.

This embodiment will be explained in more detail.

This embodiment is exemplarily configured to supply four kinds of material solutions 5a, 5b, 5c, 5d (5a, 5b, 5c are organo-metallic materials, and 5d is a solvent material such as THF) into the gas passage.

In this embodiment, to mix the carrier gas including material solutions atomized and brought into ultra-fine particle states (which are collectively called a "material gas"), there is provided a part without spiral flutes at that portion of the rod 10 which is downstream of a portion corresponding to the material supply ports 6. This part serves as a pre-mixing part 65. The material gas for three kinds of organic metals is mixed to a certain extent at the pre-mixing part 65, and then brought into a completely mixed material gas in the region of the downstream spiral structure. To obtain a uniformly mixed material gas, the length of the pre-mixing part 65 is preferably 5 to 20mm, and more preferably 8 to 15mm. Outside this range, it is likely that the vaporization part 22 is fed with a mixed material gas in which only one of the three kinds of organic metals has a higher concentration.

In this embodiment, the rod 10 is provided at its upstream end portion 66, with a parallel part 67 and a taper part 58. Also, the cylindrical hollow of the dispersion part body 1 is provided with: a parallel part having an inner diameter which is the same as an outer diameter of the parallel part 67 of the rod 10; and a taper part having the same taper with that of the taper part of the rod 10; correspondingly to the parallel part 67 and taper part 58, respectively. Thus, inserting the rod 10 from the left in the figure, causes this rod 10 to be held within the hollow of the dispersion part body 1.

Unlike the embodiment 1, since the rod 10 is held by providing it with the taper in this embodiment, there can be prevented a movement of the rod 10 even by adopting a carrier gas at a pressure higher than 3kgf/cm². Namely, adopting the holding technique shown in FIG. 8 allows a carrier gas to be flowed at a pressure of 3kg/cm² or higher. As a result, it becomes possible to decrease a cross-sectional area of the gas passage, thereby supplying a carrier gas at a higher speed with a small amount of the gas. Namely, it is also possible to supply a carrier gas at a high speed of 50 to 300mm/s. This is also true for the above embodiments, by adopting this technique.

Note that the rod 10 is formed with flutes 67a, 67b, 67c, 67d as passages for a carrier gas as shown in FIG. 9(b), at a portion of the rod corresponding to the material supply ports 6. The flutes 67a, 67b, 67c, 67d each preferably have a depth of 0.005 to 0.1mm. Depths less than 0.005mm lead to complicated molding of the flutes. 0.01 to 0.05mm are more preferable. Adoption of this range allows for elimination of occurrence of clogging or the like. Further, high-speed flows can be easily obtained.

Concerning the holding of the rod 10 and the formation of the gas passage, it is possible to adopt the configuration of the embodiment 1 shown in FIG. 1 or other configuration.

Although the spiral flute 60 may be singly provided as shown in FIG. 9(a), it can be plurally provided as shown in FIG. 10. In case of provision of a plurality of spiral flutes, they may be crossed with each other. When crossed, there can be obtained a more uniformly dispersed material gas, provided that each flute is to have a cross-sectional area which allows for obtainment of a gas flow of 10 m/sec or higher.

The dimensions and shape of the spiral flute 60 are not particularly limited, and examples thereof include the dimensions and shape shown in FIG. 9(c).

Note that the gas passage in this embodiment is cooled by cooling water 18 as shown in FIG. 8.

Further, there is independently provided a widened part 69 preceding to an inlet of the vaporization part 22 in this embodiment, and arranged in this widened part is a longitudinal radiation prevention part 102.

At the gas outlet 7 side, the radiation prevention part is formed with the small hole 101 having an inner diameter taperedly widened toward the vaporizer side.

This widened part 69 also acts as the portion described in the embodiment 3 which prevents retention of a material gas. It is of course unnecessary to independently provide the widened part 69, and this part may be provided in an integrated configuration as shown in FIG. 6.

The widened part 69 has a widened angle θ which is preferably 5 to 10 degrees. Angles θ in this range allow the material gas to be supplied to the dispersion part, without breaking spiral flows. Further, angles θ in this range minimize a fluid resistance due to the widening and minimize a presence of a dead, thereby enabling minimization of presence of swirl flow due to presence of the dead zone. Note that 6 to 7 degrees are more preferable for the θ. Further, this range of θ is preferable also in the case of the embodiment shown in FIG. 6.

### (Embodiment 6)

Supply of material solutions and carrier gas was conducted by the apparatus shown in FIG. 8 and under the following conditions, thereby investigating uniformity in a material gas.

Introduced amount of

| material solution: | |
|---|---|
| Sr(DPM)₂ | 0.04cc/min |
| Bi (C₆H₅)₃ | 0.08cc/min |
| Ta (OC₂H₅)₅ | 0.08cc/min |
| THF | 0.2cc/min |

carrier gas: nitrogen gas
10 to 350m/s

Used as the vaporization apparatus was the apparatus shown in FIG. 8. However, used as the rod was a rod shown in FIG. 9 and without formation of the spiral flute(s).

Material solutions were supplied from the material supply ports 6, and the carrier gas was variously changed in speed. Note that supplied from the material supply ports were Sr(DPM)₂ to the flute 67a, Bi(C₆H₅)₃ to flute 67b, Ta(OC₂H₅)₅ to flute 67c, and a solvent such as THF to flute 67d.

Without heating the vaporization part, there was collected a material gas at the gas outlet 7, thereby conducting measurement of particle diameter of the material solutions in the material gas.

The result is shown in FIG. 11 as a relative value (assuming a value of 1 in case of adoption of the apparatus according to the conventional example shown in FIG. 12(a)). As seen from FIG. 11, flow rates of 50m/s or faster lead to small diameters of dispersed particles, and flow rates of 100m/s or faster lead to smaller diameters of dispersed particles. However, flow rates of 200m/s or faster lead to saturated diameters of dispersed particles. Thus, more preferable is a range of 100 to 200m/s.

### (Embodiment 7)

Used in this embodiment was the rod formed with the spiral flute.

Other aspects were the same as those of the embodiment 6.

In the embodiment 6, material solutions supplied to flutes were thick in concentration at extended portions of the flutes, respectively. Namely, Sr(DPM)₂ was thick in concentration at an extended portion of the flute 67a, Bi(C₆H₅)₃ at an extended portion of the flute 67b, and Ta(OC₂H₅)₅ at an extended portion of the flute 67c.

However, in this embodiment, the mixed material gas obtained at an end of the spiral flute, was uniform in terms of the respective organo-metallic materials at any portion.

### (Embodiment 8)

FIG. 12 and FIG. 13 show an embodiment 8.

Conventionally, introduction of oxygen was conducted only at downstream of the vaporization part 22 as shown in FIG. 2. As mentioned in the section of BACKGROUND ART, there was included a large amount of carbon in a film formed by the related art. Further, there was caused a discrepancy between a compositional distribution of materials and a compositional distribution in a formed film. Namely, even when materials were adjusted to a stoichiometric composition ratio for vaporization and film-formation, actually formed films each typically had a composition ratio different from the stoichiometric ratio. Particularly, there was observed a phenomenon that bismuth was hardly included (about 0.1at%).

The present inventors have found that the reason thereof is related to an introductory position of oxygen. Namely, it was found that the composition ratio of a formed film can be made extremely less in discrepancy with that of material solutions, by introducing oxygen together with a carrier gas from a gas inlet 4, a secondary oxygen supply port 200 closest to a spout, and an oxygen supply port (primary oxygen supply port) 25, as shown in FIG. 20.

Note that it is possible to previously mix oxygen and a carrier gas with each other into a mixed gas, and the mixed gas is introduced from the gas inlet 4.

### (Embodiment 9)

There was formed an SBT film by using a vaporizer shown in FIG. 19 and FIG. 20 and a CVD apparatus shown in FIG. 21, and there were evaluated a polarization characteristic and the like.

Concretely, conditions of the vaporizer and conditions of a reaction chamber were controlled as follows, thereby forming an SBT thin-film, on an oxidized silicon substrate formed with 200nm of platinum thereon.

Concrete conditions:

| | |
|---|---|
| 0.1 mole solution of hexa-ethoxy strontium tantalum Sr [Ta(OC₂H₅)₆]₂ (solvent: hexane) | 0.02ml/min |
| tri-t-amyloxide bismuth Bi(O-t-C₅H₁₁)₃ | 0.2 mole |
| Solution (solvent: hexane) | 0.02ml/min |

| | |
|---|---|
| first carrier | Ar=200sccm (introduced from gas inlet 4) |
| first carrier | O₂=10sccm (introduced from gas inlet 4) |
| second carrier | Ar=20sccm (introduced from gas inlet 200) |
| O₂= reaction oxygen | 10sccm (introduced from gas inlet 200) O₂=200sccm (introduced from lower portion 25 of dispersion/spout part) |
| reaction oxygen temperature | 216°C (temperature is controlled by separately provided heater, before introduction from lower portion of dispersion/spout part) |

wafer temperature 475°C
space temperature 299°C
space distance 30mm
shower head temperature 201°C
reaction pressure 1 Torr
film-formation time 20 minutes

Result:

| | | |
|---|---|---|
| SBT film thickness | about 300nm | (deposition rate: about 150nm/min) |
| SBT composition | Sr 5.4at% | |
| | Bi 16.4at% | |
| | Ta 13.1at% | |
| | O 61.4at% | |
| | C 3.5at% | |

The discrepancy between the composition ratio of the formed film and the composition ratio in the material solutions was small, and the deposition rate was about 5 times as compared with the conventional. It is understood that an extremely remarkable effect is exhibited by introduction of a small amount of oxygen together with a carrier gas from the gas inlet 4. Also, the carbon content is as less as 3.5at%.

The reaction oxygen at 200cc/min was precisely temperature controlled (216°C) by a separately provided heater before the oxygen was introduced from the lower portion to the dispersion/spout part, thereby allowing confirmation of a remarkable effect for restricting recondensation and sublimation of organo-metallic compounds, based on a fact that contamination at a lower portion of the vaporization pipe was eliminated.

After formation of this SBT thin-film, there was conducted a crystallization treatment at 750°C for 30 minutes in an oxygen atmosphere to thereby form an upper electrode, followed by measurement and evaluation, to exhibit excellent crystallization characteristic and polarization characteristic. These are shown in FIG. 17 and FIG. 18, respectively.

Insofar as there is introduced an oxidative gas such as oxygen from a primary oxygen supply port closest to the gas inlet 4 or spout, it is desirable to simultaneously introduce oxygen at downstream of the vaporization part as shown in FIG. 2 so as to appropriately control an amount of oxygen, for a smaller discrepancy in composition ratio and for a decreased content of carbon.

This allows a content of carbon in a formed film, to be decreased to 5% to 20% of the conventional.

There will be explained an example of an SBT thin-film deposition process, with reference to FIG. 20.

Valve 2 is opened and valve 1 is closed to highly vacuum a reaction chamber, and there is transferred a wafer from a load lock chamber to the reaction chamber after several minutes.

At this time, the following are flowing through the vaporizer, and are drawn to a vacuum pump via valve 2 and automatic pressure regulator:

| | |
|---|---|
| 0.1 mole solution of hexa-ethoxy strontium tantalum Sr[Ta(OC₂H₅)₆]₂ (solvent: hexane) | 0.02ml/min |
| tri-t-amyloxide bismuth Bi(O-t-C₅H₁₁)₃ | 0.2 mole |
| Solution (solvent: hexane) first carrier Ar=200sccm (introduced from gas inlet 4) first carrier O₂=10sccm (introduced from gas inlet 4) | 0.02ml/min |

At this time, pressure gauge is controlled to be 4 Torr by the automatic pressure regulator.

Several minutes after the wafer is transferred, the valve 1 is opened and the valve 2 is closed when the temperature is stabilized, so as to cause the following gases to flow into the reaction chamber, thereby starting deposition.

| | |
|---|---|
| 0.1 mole solution of hexa-ethoxy strontium tantalum Sr[Ta(OC₂H₅)₆]₂ (solvent: hexane) | 0.02ml/min |
| tri-t-amyloxide bismuth Bi(O-t-C₅H₁₁)₃ | 0.2 mole |
| Solution (solvent: hexane) | 0.02ml/min |

| | |
|---|---|
| first carrier | Ar=200sccm (introduced from gas inlet 4) |
| first carrier | O₂=10sccm (introduced from gas inlet 4) |
| second carrier | Ar=20sccm (introduced from gas inlet 200) |
| O₂= | 10sccm (introduced from gas inlet 200) |
| reaction oxygen | O₂=200sccm (introduced from lower portion 25 of dispersion/spout part) |
| reaction oxygen | 216°C (temperature is controlled by |
| temperature | separately provided heater, before introduction from lower portion of dispersion/spout part) |
| wafer temperature | 475°C |

The reaction chamber pressure is controlled to be 1 Torr (this is conducted by an automatic pressure regulator (not shown)).

After a lapse of predetermined time (20 minutes here), the valve 2 is opened and valve 1 is closed to terminate deposition.

The reaction chamber is highly vacuumed to completely remove a reaction gas, and the wafer is taken out into the load lock chamber after one minute.

Capacitor Structure:
Pt (200nm)/CVDSBT (300nm)/Pt (175nm)/Ti (30nm)/SiO₂/Si

Capacitor Preparation Process:
Lower electrode formation Pt (175nm)/Ti (30nm)
CVDSBT film formation (300nm)
SBT film crystallization treatment (anneal in diffusion furnace: wafer 750°C, 30min, O₂ atmosphere)
Upper electrode formation Pt (200nm)
Anneal: 650°C, O₂, 30min

Conventionally, reaction oxygen (example: 200sccm) was introduced into a vaporization pipe in a room temperature state, so that organo-metallic gas was cooled, sticked, and deposited onto the vaporization pipe.

In a conventional case for conducting temperature control of reaction oxygen to be supplied from a lower portion of a vaporization part, a heater was wound around an exterior of a stainless tube (1/4 to 1/16 inch outer diameter, 10 to 100cm length) to control a temperature of an outer wall of the stainless tube (example: 219°C).

Further, it has been considered that "the temperature (example: 219°C) of the stainless tube outer wall"="a temperature of oxygen (flow rate 200sccm) flowing therein".

However, measurement of an oxygen temperature by a fine thermocouple has showed that the temperature was only elevated to as low as about 35°C in the above example.

As such, an oxygen temperature after heating is to be directly measured by a fine thermocouple to control the heater temperature, thereby precisely controlling the oxygen temperature.

It is not easy to elevate a temperature of a gas such as oxygen flowing through a tube, so that fillers are placed within the heated tube for an improved efficiency of heat exchange, and the temperature of heated oxygen gas is measured to properly control the heater temperature.

The means for such control is an heat exchanger shown in FIG. 20.

### (Embodiment 10)

FIG. 14 shows an embodiment 10.

Although the above embodiments are each configured to blow a gas to each singular material solution to atomize the same and then the atomized material solutions are mixed with each other, this embodiment is an apparatus configured to mix a plurality of material solutions with one another and then atomize the mixed material solutions.

This embodiment has:
a disperser 150 formed therein with: a plurality of solution passages 130a, 130b for supplying material solutions 5a, 5b; a mixing part 109 for mixing the plurality of material solutions 5a, 5b supplied from the plurality of solution passages 130a, 130b; a supply passage 110 having one end communicated with the mixing part 109, and an exit 017 located at a vaporization part 22 side; a gas passage 120 arranged to blow a carrier gas or a mixed gas of carrier gas and oxidative gas to the mixed material solutions exiting from the mixing part 109, within the supply passage 110; and cooling means for cooling the inside of the supply passage 110; and
a vaporization part 22 having: a vaporization pipe having one end connected to a reaction tube of an MOCVD apparatus and the other end connected to the exit 107 of the disperser 150; and heat means 2 for heating the vaporization pipe; so as to heat the gas including material solutions fed from the disperser 150 to thereby vaporize the material solutions;
wherein there is provided a radiation prevention part 102 having a small hole 101 outside the exit 107.

This embodiment is effective for material solutions which do not progress in reaction even when mixed with each other, and the material solutions are atomized after once mixed, thereby achieving a precise composition as compared with a case of mixing after atomizing. Further, it becomes possible to obtain a more precise composition, by providing means (not shown) for analyzing a composition of mixed material solutions at the mixing part 109, and by controlling supply amounts of the material solutions 5a, 5b, respectively, based on the analysis result.

Further, in this embodiment, it is unnecessary to use a rod (10 in FIG. 1), thereby eliminating a possibility that heat propagated through such a rod heats the inside of the supply passage 110. Furthermore, as compared with a case of mixing after atomizing, the supply passage 110 can be decreased in cross-sectional area to thereby decrease a cross-sectional area of the exit 107, so that the inside of the supply passage 110 is rarely heated by radiation. This allows for decrease of undue crystal deposition, even without providing a radiation prevention part 102. It is of course possible to provide a radiation prevention part 102 as shown in FIG. 14, when prevention of undue crystal deposition is further desired.

Note that although the embodiment is shown with an example of single small hole, a plurality of ones are of course possible. Further, the diameter of the small hole is preferably 2mm or less. In case of provision of a plurality of ones, smaller diameters are possible, respectively.

Moreover, the material solutions are drawn by the gas when the carrier flow passage and each material solution inlet define an acute angle (30°) therebetween. At 90° or larger, each solution is pushed by the gas. Thus, 30 to 90° are preferable. Concretely, the optimum angle is determined based on a viscosity and a flow rate of the applicable solution. Even in case of a larger viscosity and a larger flow rate, the applicable solution is caused to flow smoothly by adopting an acuter angle. For practice, it is thus suitable to previously obtain an optimum angle commensurate with viscosity and flow rate, by an experiment, for example.

In the above embodiment, it is further desirable to provide a mechanism for controlling a distance between a shower head and a susceptor to be an arbitrary value.

It is more desirable to provide liquid mass flow controllers for controlling flow rates of material solutions, respectively, and degasification means for degasification on the upstream side of each liquid mass flow controller. Introduction of each material solution into the associated mass flow controller without degasification causes variance in a formed film on the same wafer or in formed films on different wafers. There can be remarkably decreased variance in film thickness, by introducing material solutions into mass flow controllers, respectively, after degasification of helium or the like.

It becomes possible to further prevent variance in film thickness, by providing means for controlling temperatures of material solutions, a helium pumping container, liquid mass flow controllers, and pipings upstream and downstream of them, to be constant values, respectively. There can also be prevented degradation of chemically unstable material solutions. Precise control within a range of 5°C to 20°C is conducted for formation of an SBT thin-film. Particularly, 12°C±1°C is preferable.

Further, in a substrate surface treatment apparatus shown in FIG. 22 and FIG. 23 for blowing a predetermined gas onto a surface of a substrate such as a silicon substrate to thereby conduct treatment to the substrate surface, it is preferable to constitute such a heat medium circulation passage for bringing the gas to a predetermined temperature, including: an upstream annulus 301 connected to a heat medium inlet 320 for flow-through of heat medium; a downstream annulus 302 connected to a heat medium outlet 321 of the predetermined heat medium; and at least two heat transmission passages 303a, 303b mutually parallelly connected between the upstream annulus 1 and downstream annulus 2, thereby forming flow passages for the heat medium; wherein flow passage directions from the upstream annulus 1 to the downstream annulus 302 are alternately set between adjacent heat transmission passages 303a, 303b, respectively.

Further, the substrate surface treatment apparatus preferably includes a heat conversion plate 304 thermally connected to the heat medium circulation passage within a predetermined plane where the heat medium flow passages are formed in the parallel directions, thereby heating the inside of the plane of the heat conversion plate 304 by the heat medium to a substantially uniform temperature.

Within the plane, the heat conversion plate 304 is desirably formed with a plurality of gas vent holes for passing therethrough the predetermined gas in a vertical direction of the plane, in a manner to heat the predetermined gas passing through the vent holes to a substantially uniform temperature within the plane.

In this way, the adjacent heat transmission passages of the heat medium circulation passage are alternately constituted in flow passage direction from the upstream annulus to the downstream annulus. Thus, temperature differences between regions of the adjacent heat transmission passages are constituted in a manner of large/small/large/small···. This constitution enables the heat conversion plate to be uniformly heated or cooled. Further, the heat conversion plate thermally connected to the heat medium circulation passage is provided within the plane formed with the parallel heat medium flow passages. This enables the inside of the plane of the heat conversion plate to be heated to a substantially uniform temperature by the heat medium.

### (Embodiment 11)

FIG. 27 shows a film-formation apparatus for conducting film-formation on a surface of a strip-shaped substrate 7420 while continuously feeding the strip-shaped substrate 7420, where a plurality of vaporization apparatuses 7421a, 7421b,···, 7421g shown in FIG. 25 are provided to oppose to the surface. These vaporization apparatuses are those according to the present invention.

This enables continuous film-formation, by continuously operating film-formation apparatuses during washing of any one of the film-formation apparatuses. This is particularly preferable for fabrication of oxide superconductor. For example, film-formation of 30 minutes and washing time of 5 minutes at most, result in a film-formation time which is (30/35=6/7) of the whole. Thus, when seven vaporization apparatus 7421a through 7421g are continuously provided, there is sequentially conducted washing of 5 minutes for each of vaporization apparatuses 7421b through 7421g while film-formation for 30 minutes is conducted in the film-formation apparatus 7421a.

### INDUSTRIAL APPLICABILITY

It becomes possible to easily prevent clogging.

It becomes possible to keep track of a progressive condition of clogging of the apparatus.

It becomes possible to eliminate clogging prior to occurrence of complete clogging, without disassembling the apparatus.

## Claims

1. A vaporization apparatus for introducing a carrier gas from one end of a gas passage and for feeding, the carrier gas including a material solution, from the other end of the gas passage to a vaporization part to thereby vaporize the material solution, **characterized in**
**that** a mass flow controller (MFC) is provided at the one end of said gas passage, and means (hereinafter called "pressure detection means") for detecting a pressure within said gas passage is provided.

2. The vaporization apparatus of claim 1, **characterized in that** said vaporization apparatus is provided with means (hereinafter called "dissolution chemical solution supply means") for introducing a chemical solution capable of dissolving therein matters (hereinafter called "deposited matters and the like") deposited or sticked to the inside of said gas passage, into said gas passage.

3. The vaporization apparatus of claim 2, **characterized in that** the chemical solution is a solvent of the material solution.

4. The vaporization apparatus of any one of claims 1 through 3, **characterized in** said other end of said gas passage is smaller in diameter than the remaining portion thereof.

5. The vaporization apparatus of claim 4, **characterized in that** said other end has a diameter of 2mm or less.

6. The vaporization apparatus of any one of claims 1 through 5, **characterized in that** said vaporization apparatus is provided with means for displaying a signal from said pressure detection means.

7. A vaporization method for introducing a carrier gas from one end of a gas passage and for feeding, the carrier gas including a material solution, from the other end of the gas passage to a vaporization part to thereby vaporize the material solution, **characterized in that** said method comprises the steps of:
providing a mass flow controller (MFC) at the one end of the gas passage, and
conducting vaporization while detecting a pressure within the gas passage.

8. The vaporization method of claim 7, **characterized in that** said method further comprises the step of:
introducing a chemical solution capable of dissolving therein deposited matters and the like, when the pressure has reached a predetermined value or more.

9. The vaporization method of claim 8, **characterized in that** the chemical solution is a solvent of the material solution.

10. The vaporization method of any one of claims 7 through 9, **characterized in that** the other end of the gas passage is smaller in diameter than the remaining portion thereof.

11. The vaporization method of claim 10, **characterized in that** the other end has a diameter of 2mm or less.

12. The vaporization method of any one of claims 7 through 11, **characterized in that** said method further comprises the step of: displaying the pressure.

13. A film-formation apparatus **characterized in that** said film-formation apparatus is provided with the vaporization apparatus of any one of claims 1 through 6.

14. The film-formation apparatus of claim 13, **characterized in that** said film-formation apparatus is an MOCVD apparatus.

15. A film-formation method **characterized in that** said method comprises the step of: conducting film-formation by vaporization by the vaporization method of any one of claims 7 through 12.

16. The film-formation method of claim 15, **characterized in that** said film-formation method is an MOCVD method.

17. A film-formation apparatus for conducting film-formation on a surface of a strip-shaped substrate while continuously feeding the strip-shaped substrate, **characterized in that** said film-formation apparatus is provided with a plurality of said vaporization apparatuses of any one of claims 2 through 6 in a manner to oppose to the surface of the strip-shaped substrate.

18. A film-formation method using the film-formation apparatus of claim 17, **characterized in that** said film-formation method comprises the step of:
turning ON dissolution chemical solution supply means in any one of the plurality of vaporizers, while continuously conducting vaporization in the remaining vaporizers to continuously conduct film-formation.
